# EUROPEAN PATENT APPLICATION

(11) **EP 4 075 476 A1**
(43) Date of publication of application: **19.10.2022**
(21) Application number: 21168695.1
(22) Date of filing: 15.04.2021
(51) Int. Cl.: H01J 37/24, H01J 37/248

(54) **ELECTRON-OPTICAL DEVICE**

(71) Applicant: ASML Netherlands B.V., 5500 AH Veldhoven (NL)
(72) Inventor: STEENBRINK, Stijn, Wilem, Herman, Karel, 5500 AH Veldhoven (NL)
(74) Representative: ASML Netherlands B.V.

(57) **Abstract**

Disclosed herein is a charged-particle apparatus configured to inspect a sample with a charged-particle beam. The charged-particle apparatus comprises a detector assembly or an array of multipole elements. The charged-particle apparatus comprises an electronic device, an power source configured to output radiation, and an power converter configured to receive radiation from the power source, to convert the received radiation into electrical energy and to output the electrical energy to the electronic device. The power source is electrically isolated from the power converter.

## Description

### FIELD

The embodiments provided herein generally relate to a charged particle beam apparatus and a method of using a charged particle beam apparatus.

### BACKGROUND

When manufacturing semiconductor integrated circuit (IC) chips, undesired pattern defects may occur on a substrate (e.g. wafer) or a mask during the fabrication processes, thereby reducing the yield. Defects may occur as a consequence of, for example, optical effects and incidental particles or other processing step such as etching, deposition of chemical mechanical polishing. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection tools with a charged particle beam have been used to inspect objects, for example to detect pattern defects. These tools typically use electron microscopy techniques, such as a scanning electron microscope (SEM). In a SEM, a primary electron beam of electrons at a relatively high energy is targeted with a final deceleration step in order to land on a target at a relatively low landing energy. The beam of electrons is focused as a probing spot on the target. The interactions between the material structure at the probing spot and the landing electrons from the beam of electrons cause electrons to be emitted from the surface, such as secondary electrons, backscattered electrons or Auger electrons. The generated secondary electrons may be emitted from the material structure of the target.

By scanning the primary electron beam as the probing spot over the target surface, secondary electrons can be emitted across the surface of the target. By collecting these emitted secondary electrons from the target surface, a pattern inspection tool may obtain an image-like signal representing characteristics of the material structure of the surface of the target. In such inspection the collected secondary electrons are detected by a detector within the tool. The detector generates a signal in response to the incidental particle. As an area of the sample is inspected, the signals comprise data which is processed to generate the inspection image corresponding to the inspected area of the sample. The image may comprise pixels. Each pixel may correspond to a portion of the inspected area. Typically electron beam inspection tool has a single beam and may be referred to as a Single Beam SEM. There have been attempts to introduce a multi-electron beam inspection in a tool (or a 'multi-beam tool') which may be referred to as Multi Beam SEM (MBSEM).

Another application for an electron-optical column is lithography. The charged particle beam reacts with a resist layer on the surface of a substrate. A desired pattern in the resist can be created by controlling the locations on the resist layer that the charged particle beam is directed towards.

An electron-optical column may be an apparatus for generating, illuminating, projecting and/or detecting one or more beams of charged particles. The path of the beam of charged particles is controlled by electromagnetic fields (i.e. electrostatic fields and magnetic fields). The electron-optical elements of the column are contained within a chamber at high vacuum relative to ambient conditions.

In some electron-optical columns an electrostatic field is typically generated between electrodes of electron-optical devices within the electron-optical column, such as between two electrodes. For the desired electron optical performance high potential differences may be applied for example between the electrodes. There thus exists a risk of catastrophic electrostatic breakdown in using known architectures at the elevated potential differences. The electron-optical column may comprise one or more components require a power supply from outside the vacuum and yet are held at a high potential.

### SUMMARY

The present invention provides a suitable architecture to enable the desired electron-optical performance at higher potential differences. According to a first aspect of the invention, there is provided a charged-particle apparatus comprising an optical column and configured to project a charged-particle beam towards a sample through the optical column, the charged-particle apparatus comprising: an assembly configured to operate on charged particles in the charged-particle beam or emitted from the sample in response to the charged-particle beam; an electronic device; a power source configured to output photonic radiation; and a power converter configured to receive photonic radiation from the power source, to convert the received photonic radiation into electricity and to output the electricity to the electronic device; wherein the power source is electrically isolated from the power converter.

According to a second aspect of the invention, there is provided a charged-particle apparatus comprising an optical column and configured to project a charged-particle beam towards a sample through the optical column, the charged-particle apparatus comprising: an electronic device comprising an integrated circuit and/or an amplifier; a power source configured to output photonic radiation; and a power converter configured to receive photonic radiation from the power source, to convert the received photonic radiation into electricity and to output the electricity to the electronic device; wherein the power source is electrically isolated from the power converter.

According to a third aspect of the invention, there is provided a method of using a charged-particle apparatus, the method comprising: projecting a charged-particle beam towards a sample; operating on the charged-particle beam either in the charged-particle beam path or emitted from the sample in response to the charged-particle beam; outputting photonic radiation from a power source; receiving the photonic radiation at a power converter, the power source being electrically isolated from the power converter; converting the photonic radiation into electricity; and outputting the electricity to an electronic device of the charged-particle apparatus.

According to a fourth aspect of the invention, there is provided a method of powering a charged-particle apparatus, the method comprising: emitting photonic radiation from a power source; receiving the photonic radiation at a power converter, the power source being electrically isolated from the power source; converting the photonic radiation into electricity; and powering an integrated circuit and/or an amplifier of an electronic device with the electricity.

Advantages of the present invention will become apparent from the following description taken in conjunction with the accompanying drawings wherein are set forth, by way of illustration and example, certain embodiments of the present invention.

### BRIEF DESCRIPTION OF FIGURES

The above and other aspects of the present disclosure will become more apparent from the description of exemplary embodiments, taken in conjunction with the accompanying drawings.
Figure 1 is a schematic diagram illustrating an exemplary electron beam inspection apparatus.
Figure 2 is a schematic diagram illustrating an exemplary multi-beam electron-optical column that is part of the exemplary inspection apparatus of Figure 1.
Figure 3 is a schematic diagram of an exemplary electron-optical system comprising a collimator element array and a scan-deflector array that is part of the exemplary inspection apparatus of Figure 1.
Figure 4 is a schematic diagram of an exemplary electron-optical system array comprising the electron optical systems of Figure 3.
Figure 5 is a schematic diagram of an alternative exemplary electron-optical system that is part of the exemplary inspection apparatus of Figure 1.
Figure 6 is a schematic diagram of an alternative exemplary electron-optical system that is part of the exemplary inspection apparatus of Figure 1.
Figure 7 is a schematic diagram of part of an electron beam apparatus.
Figure 8 is a schematic diagram of part of an electron beam apparatus.
Figure 9 is a schematic diagram of part of an electron beam apparatus.
Figure 10 is a schematic diagram of a detector assembly that is part of an electron beam apparatus.
Figure 11 is a schematic diagram of part of a sensor assembly that is part of an electron beam apparatus.
Figure 12 is a schematic diagram of part of a sensor assembly that is part of an electron beam apparatus.
Figure 13 is a schematic diagram of an array of multipole deflectors that is part of an electron beam apparatus.

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

### DETAILED DESCRIPTION

The reduction of the physical size of devices, and enhancement of the computing power of electronic devices, may be accomplished by significantly increasing the packing density of circuit components such as transistors, capacitors, diodes, etc. on an IC chip. This has been enabled by increased resolution enabling yet smaller structures to be made. Semiconductor IC manufacturing is a complex and time-consuming process, with hundreds of individual steps. An error in any step of the process of manufacturing an IC chip has the potential to adversely affect the functioning of the final product. Just one defect could cause device failure. It is desirable to improve the overall yield of the process. For example, to obtain a 75% yield for a 50-step process (where a step may indicate the number of layers formed on a wafer), each individual step must have a yield greater than 99.4%,. If an individual step has a yield of 95%, the overall process yield would be as low as 7-8%.

Maintaining a high substrate (i.e. wafer) throughput, defined as the number of substrates processed per hour, is also desirable. High process yield and high substrate throughput may be impacted by the presence of a defect. This is especially true if operator intervention is required for reviewing the defects. High throughput detection and identification of micro and nano-scale defects by inspection tools (such as a Scanning Electron Microscope ('SEM')) is desirable for maintaining high yield and low cost for IC chips.

A SEM comprises an scanning device and a detector apparatus. The scanning device comprises an illumination apparatus that comprises an electron source, for generating primary electrons, and a projection apparatus for scanning a target, such as a substrate, with one or more focused beams of primary electrons. The primary electrons interact with the target and generate interaction products, such as secondary electrons and/or backscattered electrons. The detection apparatus captures the secondary electrons and/or backscattered electrons from the target as the target is scanned so that the SEM may create an image of the scanned area of the target. A design of electron-optical tool embodying these SEM features may have a single beam. For higher throughput such as for inspection, some designs of apparatus use multiple focused beams, i.e. a multi-beam, of primary electrons. The component beams of the multi-beam may be referred to as sub-beams or beamlets. A multi-beam may scan different parts of a target simultaneously. A multi-beam inspection apparatus may therefore inspect a target much quicker, e.g. by moving the target at a higher speed, than a single-beam inspection apparatus.

In a multi-beam inspection apparatus, the paths of some of the primary electron beams are displaced away from the central axis, i.e. a mid-point of the primary electron-optical axis (which may also be referred to as the charged particle axis), of the scanning device. To ensure all the electron beams arrive at the sample surface with substantially the same angle of incidence, sub-beam paths with a greater radial distance from the central axis need to be manipulated to move through a greater angle than the sub-beam paths with paths closer to the central axis. This stronger manipulation may cause aberrations that cause the resulting image to be blurry and out-of-focus. An example is spherical aberrations which bring the focus of each sub-beam path into a different focal plane. In particular, for sub-beam paths that are not on the central axis, the change in focal plane in the sub-beams is greater with the radial displacement from the central axis. Such aberrations and de-focus effects may remain associated with the secondary electrons from the target when they are detected, for example the shape and size of the spot formed by the sub-beam on the target will be affected. Such aberrations therefore degrade the quality of resulting images that are created during inspection.

An implementation of a known multi-beam inspection apparatus is described below.

The Figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred with reference to electrons, throughout the present document may therefore be more generally be considered to be references to charged particles, and items referred to in reference to charged particles, with the charged particles not necessarily being electrons. Similarly, references to an electron or an electron beam as a qualifier for an apparatus may be more generally be considered to be references to a charged particle or a charged particle beam. For example, reference to an electron beam inspection apparatus may be considered to be a reference to a charged particle beam inspection apparatus.

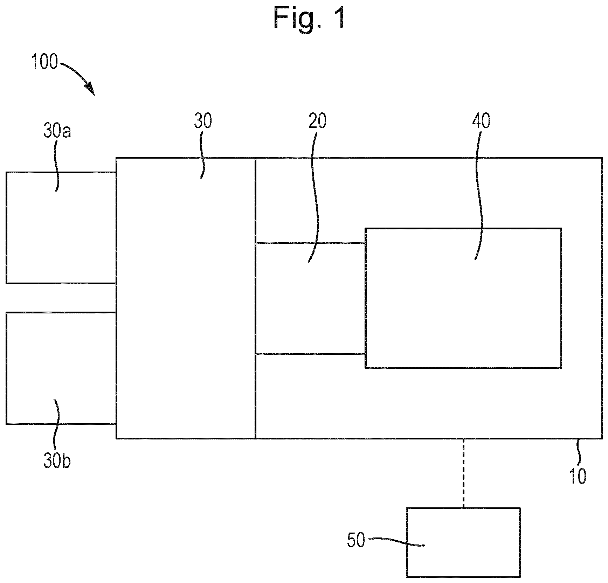

Reference is now made to Figure 1, which is a schematic diagram illustrating an exemplary electron beam inspection apparatus 100. The inspection apparatus 100 of Figure 1 includes a vacuum chamber 10, a load lock chamber 20, an electron-optical column 40 (also known as an electron beam column), an equipment front end module (EFEM) 30 and a controller 50. The electron optical column 40 may be within the vacuum chamber 10.

The EFEM 30 includes a first loading port 30a and a second loading port 30b. The EFEM 30 may include additional loading port(s). The first loading port 30a and second loading port 30b may, for example, receive substrate front opening unified pods (FOUPs) that contain substrates (e.g., semiconductor substrates or substrates made of other material(s)) or targets to be inspected (substrates, wafers and samples are collectively referred to as "targets" hereafter). One or more robot arms (not shown) in EFEM 30 transport the targets to load lock chamber 20.

The load lock chamber 20 is used to remove the gas around a target. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. The main chamber 10 is connected to a main chamber vacuum pump system (not shown). The main chamber 10 may have a vacuum pressure of about 1x10⁻⁸ Pa to about 1x10⁻³ Pa. The main chamber vacuum pump system removes gas molecules in the main chamber 10 so that the pressure around the target reaches a second pressure lower than the first pressure. After reaching the second pressure, the target is transported to the electron-optical column 40 by which it may be inspected. An electron-optical column 40 may comprise either a single beam or a multi-beam electron-optical apparatus.

The controller 50 is electronically connected to the electron-optical column 40. The controller 50 may be a processor (such as a computer) configured to control the electron beam inspection apparatus 100. The controller 50 may also include a processing circuitry configured to execute various signal and image processing functions. While the controller 50 is shown in Figure 1 as being outside of the structure that includes the main chamber 10, the load lock chamber 20, and the EFEM 30, it is appreciated that the controller 50 may be part of the structure. The controller 50 may be located in one of the component elements of the electron beam inspection apparatus 100 or it may be distributed over at least two of the component elements. While the present disclosure provides examples of main chamber 10 housing an electron beam inspection tool, it should be noted that aspects of the disclosure in their broadest sense are not limited to a chamber housing an electron beam column. Rather, it is appreciated that the foregoing principles may also be applied to other tools and other arrangements of apparatus that operate under the second pressure.

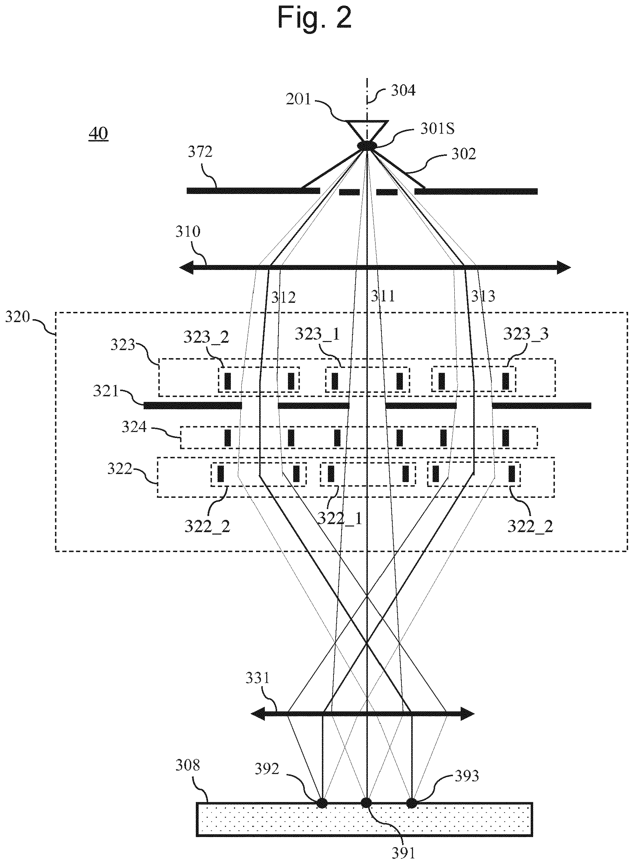

Reference is now made to Figure 2, which is a schematic diagram of an exemplary multi-beam electron-optical column 40 of the inspection apparatus 100 of Figure 1. In an alternative embodiment the inspection apparatus 100 is a single-beam inspection apparatus. The electron-optical column 40 may comprise an electron source 201, a beam former array 372 (also known as a gun aperture plate, a coulomb aperture array or a pre-sub-beam-forming aperture array), a condenser lens 310, a source converter (or micro-optical array) 320, an objective lens 331, and a target 308. In an embodiment the condenser lens 310 is magnetic. The target 308 may be supported by a support on a stage. The stage may be motorized. The stage moves so that the target 308 is scanned by the incidental electrons. The electron source 201, the beam former array 372, the condenser lens 310 may be the components of an illumination apparatus comprised by the electron-optical column 40. The source converter 320 (also known as a source conversion unit), described in more detail below, and the objective lens 331 may be the components of a projection apparatus comprised by the electron-optical column 40.

The electron source 201, the beam former array 372, the condenser lens 310, the source converter 320, and the objective lens 331 are aligned with a primary electron-optical axis 304 of the electron-optical column 40. The electron source 201 may generate a primary beam 302 generally along the electron-optical axis 304 and with a source crossover (virtual or real) 301S. During operation, the electron source 201 is configured to emit electrons. The electrons are extracted or accelerated by an extractor and/or an anode to form the primary beam 302.

The beam former array 372 cuts the peripheral electrons of primary electron beam 302 to reduce a consequential Coulomb effect. The primary-electron beam 302 may be trimmed into a specified number of sub-beams, such as three sub-beams 311, 312 and 313, by the beam former array 372. It should be understood that the description is intended to apply to an electron-optical column 40 with any number of sub-beams such as one, two or more than three. The beam former array 372, in operation, is configured to block off peripheral electrons to reduce the Coulomb effect. The Coulomb effect may enlarge the size of each of the probe spots 391, 392, 393 and therefore deteriorate inspection resolution. The beam former array 372 reduces aberrations resulting from Coulomb interactions between electrons projected in the beam. The beam former array 372 may include multiple openings for generating primary sub-beams even before the source converter 320.

The source converter 320 is configured to convert the beam (including sub-beams if present) transmitted by the beam former array 372 into the sub-beams that are projected towards the target 308. In an embodiment the source converter is a unit. Alternatively, the term source converter may be used simply as a collective term for the group of components that form the beamlets from the sub-beams.

As shown in Figure 2, in an embodiment the electron-optical column 40 comprises a beam-limiting aperture array 321 with an aperture pattern (i.e. apertures arranged in a formation) configured to define the outer dimensions of the beamlets (or sub-beams) projected towards the target 308. In an embodiment the beam-limiting aperture array 321 is part of the source converter 320. In an alternative embodiment the beam-limiting aperture array 321 is part of the system up-beam of the main column. In an embodiment, the beam-limiting aperture array 321 divides one or more of the sub-beams 311, 312, 313 into beamlets such that the number of beamlets projected towards the target 308 is greater than the number of sub-beams transmitted through the beam former array 372. In an alternative embodiment, the beam-limiting aperture array 321 keeps the number of the sub-beams incident on the beam-limiting aperture array 321, in which case the number of sub-beams may equal the number of beamlets projected towards the target 308.

As shown in Figure 2, in an embodiment the electron-optical column 40 comprises a pre-bending deflector array 323 with pre-bending deflectors 323_1, 323_2, and 323_3 to bend the sub-beams 311, 312, and 313 respectively. The pre-bending deflectors 323_1, 323_2, and 323_3 may bend the path of the sub-beams 311, 312, and 313 onto the beam-limiting aperture array 321.

The electron-optical column 40 may also include an image-forming element array 322 with image-forming deflectors 322_1, 322_2, and 322_3. There is a respective deflector 322_1, 322_2, and 322_3 associated with the path of each beamlet. The deflectors 322_1, 322_2, and 322_3 are configured to deflect the paths of the beamlets towards the electron-optical axis 304. The deflected beamlets form virtual images (not shown) of source crossover 301S. In the current embodiment, these virtual images are projected onto the target 308 by the objective lens 331 and form probe spots 391, 392, 393 thereon. The electron-optical column 40 may also include an aberration compensator array 324 configured to compensate aberrations that may be present in each of the sub-beams. In an embodiment the aberration compensator array 324 comprises a lens configured to operate on a respective beamlet. The lens may take the form or an array of lenses. The lenses in the array may operate on a different beamlet of the multi-beam. The aberration compensator array 324 may, for example, include a field curvature compensator array (not shown) for example with micro-lenses. The field curvature compensator and micro-lenses may, for example, be configured to compensate the individual sub-beams for field curvature aberrations evident in the probe spots, 391, 392, and 393. The aberration compensator array 324 may include an astigmatism compensator array (not shown) with micro-stigmators. The micro-stigmators may, for example, be controlled to operate on the sub-beams to compensate astigmatism aberrations that are otherwise present in the probe spots, 391, 392, and 393.

The source converter 320 may further comprise a pre-bending deflector array 323 with pre-bending deflectors 323_1, 323_2, and 323_3 to bend the sub-beams 311, 312, and 313 respectively. The pre-bending deflectors 323_1, 323_2, and 323_3 may bend the path of the sub-beams onto the beam-limiting aperture array 321. In an embodiment, the pre-bending micro-deflector array 323 may be configured to bend the sub-beam path of sub-beams towards the orthogonal of the plane of on beam-limiting aperture array 321. In an alternative embodiment the condenser lens 310 may adjust the path direction of the sub-beams onto the beam-limiting aperture array 321. The condenser lens 310 may, for example, focus (collimate) the three sub-beams 311, 312, and 313 to become substantially parallel beams along primary electron-optical axis 304, so that the three sub-beams 311, 312, and 313 incident substantially perpendicularly onto source converter 320, which may correspond to the beam-limiting aperture array 321. In such alternative embodiment the pre-bending deflector array 323 may not be necessary.

The image-forming element array 322, the aberration compensator array 324, and the pre-bending deflector array 323 may comprise multiple layers of sub-beam manipulating devices, some of which may be in the form or arrays, for example: micro-deflectors, micro-lenses, or micro-stigmators. Beam paths may be manipulated rotationally. Rotational corrections may be applied by a magnetic lens. Rotational corrections may additionally, or alternatively, be achieved by an existing magnetic lens such as the condenser lens arrangement.

In the current example of the electron-optical column 40, the beamlets are respectively deflected by the deflectors 322_1, 322_2, and 322_3 of the image-forming element array 322 towards the electron-optical axis 304. It should be understood that the beamlet path may already correspond to the electron-optical axis 304 prior to reaching deflector 322_1, 322_2, and 322_3.

The objective lens 331 focuses the beamlets onto the surface of the target 308, i.e., it projects the three virtual images onto the target surface. The three images formed by three sub-beams 311 to 313 on the target surface form three probe spots 391, 392 and 393 thereon. In an embodiment the deflection angles of sub-beams 311 to 313 are adjusted to pass through or approach the front focal point of objective lens 331 to reduce or limit the off-axis aberrations of three probe spots 391 to 393. In an arrangement the objective lens 331 is magnetic. Although three beamlets are mentioned, this is by way of example only. There may be any number of beamlets.

A manipulator is configured to manipulate one or more beams of electrons. The term manipulator encompasses a deflector, a lens and an aperture. The pre-bending deflector array 323, the aberration compensator array 324 and the image-forming element array 322 may individually or in combination with each other, be referred to as a manipulator array, because they manipulate one or more sub-beams or beamlets of electrons. The lens and the deflectors 322_1, 322_2, and 322_3 may be referred to as manipulators because they manipulate one or more sub-beams or beamlets of electrons.

In an embodiment a beam separator (not shown) is provided. The beam separator may be down-beam of the source converter 320. The beam separator may be, for example, a Wien filter comprising an electrostatic dipole field and a magnetic dipole field. The beam separator may be positioned between adjacent sections of shielding (described in more detail below) in the direction of the beam path. The inner surface of the shielding may be radially inward of the beam separator. Alternatively, the beam separator may be within the shielding. In operation, the beam separator may be configured to exert an electrostatic force by electrostatic dipole field on individual electrons of sub-beams. In an embodiment, the electrostatic force is equal in magnitude but opposite in direction to the magnetic force exerted by the magnetic dipole field of beam separator on the individual primary electrons of the sub-beams. The sub-beams may therefore pass at least substantially straight through the beam separator with at least substantially zero deflection angles. The direction of the magnetic force depends on the direction of motion of the electrons while the direction of the electrostatic force does not depend on the direction of motion of the electrons. So because the secondary electrons and backscattered electrons generally move in an opposite direction compared to the primary electrons, the magnetic force exerted on the secondary electrons and backscattered electrons will no longer cancel the electrostatic force and as a result the secondary electrons and backscattered electrons moving through the beam separator will be deflected away from the electron-optical axis 304.

In an embodiment a secondary column (not shown) is provided comprising detection elements for detecting corresponding secondary electron beams. On incidence of secondary beams with the detection elements, the elements may generate corresponding intensity signal outputs. The outputs may be directed to an image processing system (e.g., controller 50). Each detection element may comprise an array which may be in the form of a grid. The array may have one or more pixels; each pixel may correspond to an element of the array. The intensity signal output of a detection element may be a sum of signals generated by all the pixels within the detection element.

In an embodiment a secondary projection apparatus and its associated electron detection device (not shown) are provided. The secondary projection apparatus and its associated electron detection device may be aligned with a secondary electron-optical axis of the secondary column. In an embodiment the beam separator is arranged to deflect the path of the secondary electron beams towards the secondary projection apparatus. The secondary projection apparatus subsequently focuses the path of secondary electron beams onto a plurality of detection regions of the electron detection device. The secondary projection apparatus and its associated electron detection device may register and generate an image of the target 308 using the secondary electrons or backscattered electrons.

In an embodiment the inspection apparatus 100 comprises a single source.

Any element or collection of elements may be replaceable or field replaceable within the electron-optical column. The one or more electron-optical components in the column, especially those that operate on sub-beams or generate sub-beams, such as aperture arrays and manipulator arrays may comprise one or more microelectromechanical systems (MEMS). The pre-bending deflector array 323 may be a MEMS. MEMS are miniaturized mechanical and electromechanical elements that are made using microfabrication techniques. In an embodiment the electron-optical column 40 comprises apertures, lenses and deflectors formed as MEMS. In an embodiment, the manipulators such as the lenses and deflectors 322_1, 322_2, and 322_3 are controllable, passively, actively, as a whole array, individually or in groups within an array, so as to control the beamlets of electrons projected towards the target 308.

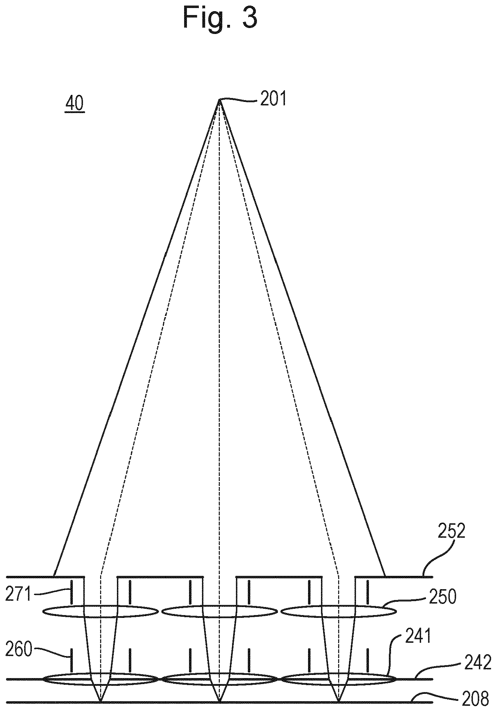

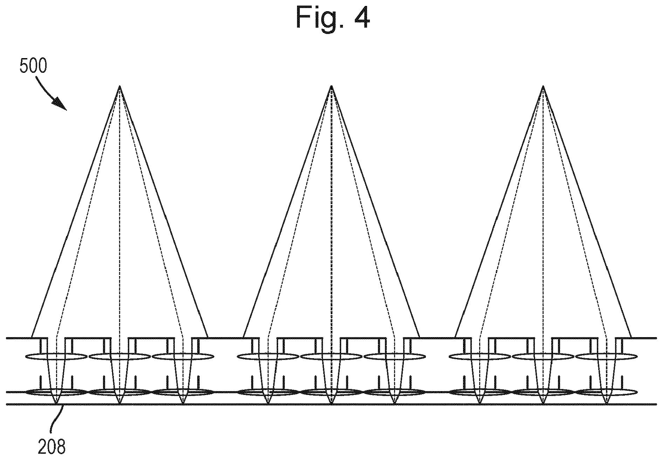

In an embodiment the electron-optical column 40 may comprise alternative and/or additional components on the electron path, such as lenses and other components some of which have been described earlier with reference to Figures. 1 and 2. Examples of such arrangements are shown in Figures 3 and 4 which are described in further detail later. In particular, embodiments include an electron-optical column 40 that divides an electron beam from a source into a plurality of sub-beams. A plurality of respective objective lenses may project the sub-beams onto a sample. In some embodiments, a plurality of condenser lenses is provided up-beam from the objective lenses. The condenser lenses focus each of the sub-beams to an intermediate focus up-beam of the objective lenses. In some embodiments, collimators are provided up-beam from the objective lenses. Correctors may be provided to reduce focus error and/or aberrations. In some embodiments, such correctors are integrated into or positioned directly adjacent to the objective lenses. Where condenser lenses are provided, such correctors may additionally, or alternatively, be integrated into, or positioned directly adjacent to, the condenser lenses and/or positioned in, or directly adjacent to, the intermediate foci. A detector is provided to detect electrons emitted by the sample. The detector may be integrated into the objective lens. The detector may be on the bottom surface of the objective lens so as to face a sample in use. The detector may comprise an array which may correspond to the array of the beamlets of the multi-beam arrangement. The detectors in the detector array may generate detection signals that may be associated with the pixels of a generated image. The condenser lenses, objective lenses and/or detector may be formed as MEMS or CMOS devices.

Figure 3 is a schematic diagram of another design of exemplary electron-optical system. The electron-optical system may comprise a source 201 and electron-optical column. The electron optical column may comprise an upper beam limiter 252, a collimator element array 271, a control lens array 250, a scan deflector array 260, an objective lens array 241, a beam shaping limiter 242 and a detector array. The source 201 provides a beam of electrons. The multi-beam focused on the sample 208 is derived from the beam provided by the source 201. Sub-beams may be derived from the beam, for example, using a beam limiter defining an array of beam-limiting apertures. The source 201 is desirably a high brightness thermal field emitter with a good compromise between brightness and total emission current.

The upper beam limiter 252 defines an array of beam-limiting apertures. The upper beam limiter 252 may be referred to as an upper beam-limiting aperture array or up-beam beam-limiting aperture array. The upper beam limiter 252 may comprise a plate (which may be a plate-like body) having a plurality of apertures. The upper beam limiter 252 forms the sub-beams from the beam of electrons emitted by the source 201. Portions of the beam other than those contributing to forming the sub-beams may be blocked (e.g. absorbed) by the upper beam limiter 252 so as not to interfere with the sub-beams down-beam. The upper beam limiter 252 may be referred to as a sub-beam defining aperture array.

The collimator element array 271 is provided down-beam of the upper beam limiter. Each collimator element collimates a respective sub-beam. The collimator element array 271 may be formed using MEMS manufacturing techniques so as to be spatially compact. In some embodiments, exemplified in Figure 3, the collimator element array 271 is the first deflecting or focusing electron-optical array element in the beam path down-beam of the source 201. In another arrangement, the collimator may take the form, wholly or partially, of a macro-collimator. Such a macro-collimator may be up beam of the upper beam limiter 252 so it operates on the beam from the source before generation of the multi-beam. A magnetic lens may be used as the macro-collimator.

Down-beam of the collimator element array there is the control lens array 250. The control lens array 250 comprises a plurality of control lenses. Each control lens comprises at least two electrodes (e.g. two or three electrodes) connected to respective potential sources. The control lens array 250 may comprise two or more (e.g. three) plate electrode arrays connected to respective potential sources. The control lens array 250 is associated with the objective lens array 241 (e.g. the two arrays are positioned close to each other and/or mechanically connected to each other and/or controlled together as a unit). The control lens array 250 is positioned up-beam of the objective lens array 241. The control lenses pre-focus the sub-beams (e.g. apply a focusing action to the sub-beams prior to the sub-beams reaching the objective lens array 241). The pre-focusing may reduce divergence of the sub-beams or increase a rate of convergence of the sub-beams.

For ease of illustration, lens arrays are depicted schematically herein by arrays of oval shapes. Each oval shape represents one of the lenses in the lens array. The oval shape is used by convention to represent a lens, by analogy to the biconvex form often adopted in optical lenses. In the context of electron-optical arrangements such as those discussed herein, it will be understood however that lens arrays will typically operate electrostatically and so may not require any physical elements adopting a biconvex shape. As described above, lens arrays may instead comprise multiple plates with apertures.

The scan-deflector array 260 comprising a plurality of scan deflectors may be provided. The scan-deflector array 260 may be formed using MEMS manufacturing techniques. Each scan deflector scans a respective sub-beam over the sample 208. The scan-deflector array 260 may thus comprise a scan deflector for each sub-beam. Each scan deflector may deflect the sub-beam in one direction (e.g. parallel to a single axis, such as an X axis) or in two directions (e.g. relative to two non-parallel axes, such as X and Y axes). The deflection is such as to cause the sub-beam to be scanned across the sample 208 in the one or two directions (i.e. one dimensionally or two dimensionally). In an embodiment, the scanning deflectors described in EP2425444, which document is hereby incorporated by reference in its entirety specifically in relation to scan deflectors, may be used to implement the scan-deflector array 260. A scan-deflector array 260 (e.g. formed using MEMS manufacturing techniques as mentioned above) may be more spatially compact than a macro scan deflector. In another arrangement, a macro scan deflector may be used up beam of the upper beam limiter 252. Its function may be similar or equivalent to the scan-deflector array although it operates on the beam from the source before the beamlets of the multi-beam are generated.

The objective lens array 241 comprising a plurality of objective lenses is provided to direct the sub-beams onto the sample 208. Each objective lens comprises at least two electrodes (e.g. two or three electrodes) connected to respective potential sources. The objective lens array 241 may comprise two or more (e.g. three) plate electrode arrays connected to respective potential sources. Each objective lens formed by the plate electrode arrays may be a micro-lens operating on a different sub-beam. Each plate defines a plurality of apertures (which may also be referred to as holes). The position of each aperture in a plate corresponds to the position of a corresponding aperture (or apertures) in the other plate (or plates). The corresponding apertures define the objective lenses and each set of corresponding apertures therefore operates in use on the same sub-beam in the multi-beam. Each objective lens projects a respective sub-beam of the multi-beam onto a sample 208.

The objective lens array may form part of an objective lens array assembly along with any or all of the scan-deflector array 260, control lens array 250 and collimator element array 271. The objective lens array assembly may further comprise the beam shaping limiter 242. The beam shaping limiter 242 defines an array of beam-limiting apertures. The beam shaping limiter 242 may be referred to as a lower beam limiter, lower beam-limiting aperture array or final beam-limiting aperture array. The beam shaping limiter 242 may comprise a plate (which may be a plate-like body) having a plurality of apertures. The beam shaping limiter 242 is down-beam from at least one electrode (optionally from all electrodes) of the control lens array 250. In some embodiments, the beam shaping limiter 242 is down-beam from at least one electrode (optionally from all electrodes) of the objective lens array 241.

In an arrangement, the beam shaping limiter 242 is structurally integrated with an electrode 302 of the objective lens array 241. Desirably, the beam shaping limiter 242 is positioned in a region of low electrostatic field strength. Each of the beam-limiting apertures is aligned with a corresponding objective lens in the objective lens array 241. The alignment is such that a portion of a sub-beam from the corresponding objective lens can pass through the beam-limiting aperture and impinge onto the sample 208. Each beam-limiting aperture has a beam limiting effect, allowing only a selected portion of the sub-beam incident onto the beam shaping limiter 242 to pass through the beam-limiting aperture. The selected portion may be such that only a portion of the respective sub-beam passing through a central portion of respective apertures in the objective lens array reaches the sample. The central portion may have a circular cross-section and/or be centered on a beam axis of the sub-beam.

In an embodiment, the electron-optical system is configured to control the objective lens array assembly (e.g. by controlling potentials applied to electrodes of the control lens array 250) so that a focal length of the control lenses is larger than a separation between the control lens array 250 and the objective lens array 241. The control lens array 250 and objective lens array 241 may thus be positioned relatively close together, with a focusing action from the control lens array 250 that is too weak to form an intermediate focus between the control lens array 250 and objective lens array 241. The control lens array and the objective lens array operate together to for a combined focal length to the same surface. Combined operation without an intermediate focus may reduce the risk of aberrations. In other embodiments, the objective lens array assembly may be configured to form an intermediate focus between the control lens array 250 and the objective lens array 241.

An electric power source may be provided to apply respective potentials to electrodes of the control lenses of the control lens array 250 and the objective lenses of the objective lens array 241.

The provision of a control lens array 250 in addition to an objective lens array 241 provides additional degrees of freedom for controlling properties of the sub-beams. The additional freedom is provided even when the control lens array 250 and objective lens array 241 are provided relatively close together, for example such that no intermediate focus is formed between the control lens array 250 and the objective lens array 241. The control lens array 250 may be used to optimize a beam opening angle with respect to the demagnification of the beam and/or to control the beam energy delivered to the objective lens array 241. The control lens may comprise two or three or more electrodes. If there are two electrodes then the demagnification and landing energy are controlled together. If there are three or more electrodes the demagnification and landing energy can be controlled independently. The control lenses may thus be configured to adjust the demagnification and/or beam opening angle and/or the landing energy on the substrate of respective sub-beams (e.g. using the electric power source to apply suitable respective potentials to the electrodes of the control lenses and the objective lenses). This optimization can be achieved without having an excessively negative impact on the number of objective lenses and without excessively deteriorating aberrations of the objective lenses (e.g. without decreasing the strength of the objective lenses). Use of the control lens array enables the objective lens array to operate at its optimal electric field strength. Note that it is intended that the reference to demagnification and opening angle is intended to refer to variation of the same parameter. In an ideal arrangement the product of a range of demagnification and the corresponding opening angles is constant. However, the opening angle may be influenced by the use of an aperture.

In an embodiment, the landing energy can be controlled to a desired value in a predetermined range, e.g. from 1000 eV to 5000 eV. Desirably, the landing energy is primarily varied by controlling the energy of the electrons exiting the control lens. The potential differences within the objective lenses are preferably kept constant during this variation so that the electric field within the objective lens remains as high as possible. The potentials applied to the control lens in addition may be used to optimize the beam opening angle and demagnification. The control lens can function to change the demagnification in view of changes in landing energy. Desirably, each control lens comprises three electrodes so as to provide two independent control variables. For example, one of the electrodes can be used to control magnification while a different electrode can be used to independently control landing energy. Alternatively each control lens may have only two electrodes. When there are only two electrodes, one of the electrodes may need to control both magnification and landing energy.

The detector array (not shown) is provided to detect electrons emitted from the sample 208. The detected electrons may include any of the electrons detected by an SEM, including secondary and/or backscattered electrons emitted from the sample 208. The detector may be an array providing the surface of the column facing the sample 208, e.g. the bottom surface of the column. Alternative the detector array be up beam of the bottom surface or example in or up beam of the objective lens array or the control lens array. The elements of the detector array may correspond to the beamlets of the multi-beam arrangement. The signal generated by detection of an electron by an element of the array be transmitted to a processor for generation of an image. The signal may correspond to a pixel of an image.

In other embodiments both a macro scan deflector and the scan-deflector array 260 are provided. In such an arrangement, the scanning of the sub-beams over the sample surface may be achieved by controlling the macro scan deflector and the scan-deflector array 260 together, preferably in synchronization.

In an embodiment, as exemplified in Figure 4, an electron-optical system array 500 is provided. The array 500 may comprise a plurality of any of the electron-optical systems described herein. Each of the electron-optical systems focuses respective multi-beams simultaneously onto different regions of the same sample. Each electron-optical system may form sub-beams from a beam of electrons from a different respective source 201. Each respective source 201 may be one source in a plurality of sources 201. At least a subset of the plurality of sources 201 may be provided as a source array. The source array may comprise a plurality of sources 201 provided on a common substrate. The focusing of plural multi-beams simultaneously onto different regions of the same sample allows an increased area of the sample 208 to be processed (e.g. assessed) simultaneously. The electron-optical systems in the array 500 may be arranged adjacent to each other so as to project the respective multi-beams onto adjacent regions of the sample 208.

Any number of electron-optical systems may be used in the array 500. Preferably, the number of electron-optical systems is in the range of from 2 (preferably 9) to 200. In an embodiment, the electron-optical systems are arranged in a rectangular array or in a hexagonal array. In other embodiments, the electron-optical systems are provided in an irregular array or in a regular array having a geometry other than rectangular or hexagonal. Each electron-optical system in the array 500 may be configured in any of the ways described herein when referring to a single electron-optical system. For example the objective lens may be incorporated and adapted for use in the multi-column arrangement as described in EPA 20184161.6 filed 6 July 2020, which description at least in respect to the objective lens including in the manner it is incorporated and adapted for use in such a multi-column arrangement is hereby incorporated by reference.

In the example of Figure 4 the array 500 comprises a plurality of electron-optical systems of the type described above with reference to Figure 3. Each of the electron-optical systems in this example thus comprise both a scan-deflector array 260 and a collimator element array 271. As mentioned above, the scan-deflector array 260 and collimator element array 271 are particularly well suited to incorporation into an electron-optical system array 500 because of their spatial compactness, which facilitates positioning of the electron-optical systems close to each other. This arrangement of electron optical column may be preferred over other arrangements that use a magnetic lens as collimator. Magnetic lenses may be challenging to incorporate into an electron-optical column intended for use in a multi-column arrangement.

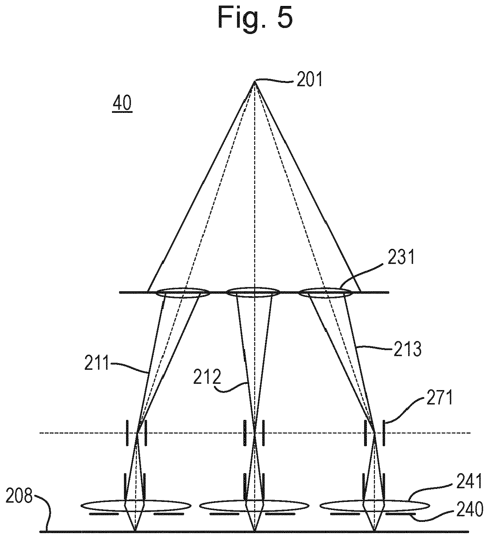

An alternative design of multi-beam electron optical column may have the same features as described with respect to Figure 3 expect as described below and illustrated in Figure 5. The alternative design of multi-beam electron optical column may comprise a condenser lens array 231 upbeam of the object lens array arrangement 241, as disclosed in EP application 20158804.3 filed on 21 February 2020 which is hereby incorporated by reference so far as the description of the multi-beam column with a collimator and its components. Such a design does not require the beam shaping limiter array 242 or the upper beam limiter array 252 because a beam limiting aperture array associated with condenser lens array 231 may shape the beamlets 211, 212, 213 of the multi-beam from the beam of the source 201. The beam limiting aperture array of the condenser lens may also function as an electrode in the lens array.

The paths of the beamlets 211, 212, 213 diverge away from the condenser lens array 231. The condenser lens array 231 focuses the generated beamlets to an intermediate focus between the condenser lens array 231 and the objective lens array assembly 241 (i.e. towards the control lens array and the objective lens array). The collimator array 271 may be at the intermediate foci instead of associated with the objective lens array assembly 241.

The collimator may reduce the divergence of the diverging beamlet paths. The collimator may collimate the diverging beamlet paths so that they are substantially parallel towards the objective lens array assembly. Corrector arrays may be present in the multi-beam path, for example associated with the condenser lens array, the intermediate foci and the objective lens array assembly. The detector 240 may be integrated into the objective lens 241. The detector 240 may be on the bottom surface of the objective lens 241 so as to face a sample in use. For example, the detector array may be implemented by integrating a CMOS chip detector into a bottom electrode of the objective lens array.

An electron-optical system array may have multiple multi-beam columns of this design as described with reference to the multi-beam column of Figure 3 as shown in Figure 4. Such an arrangement is shown and described in EP Application 20158732.6 filed on 21 February 2020 which is hereby incorporated by reference with respect to the multi-column arrangement of a multi-beam tool featuring the design of multi-beam column disclosed with a collimator at an intermediate focus.

A further alternative design of multi-beam tool comprises multiple single beam columns. The single beams generated for the purposes of the invention herein described may be similar or equivalent to a multi-beam generated by a single column. Such a multi-column tool may have one hundred columns each generating a single beam or beamlet. In this further alternative design the single beam columns may have a common vacuum system, each column have a separate vacuum system or groups of columns are assigned different vacuum systems. Each column may have an associated detector.

The electron-optical column 40 may be a component of an inspection (or metro-inspection) tool or part of an e-beam lithography tool. The multi-beam apparatus may be used in a number of different applications that include electron microscopy in general, not just SEM, and lithography.

The electron-optical axis 304 describes the path of electrons through and output from the source 201. The sub-beams and beamlets of a multi-beam may all be substantially parallel to the electron-optical axis 304 at least through the manipulators or electron -optical arrays, unless explicitly mentioned. The electron-optical axis 304 may be the same as, or different from, a mechanical axis of the electron-optical column 40.

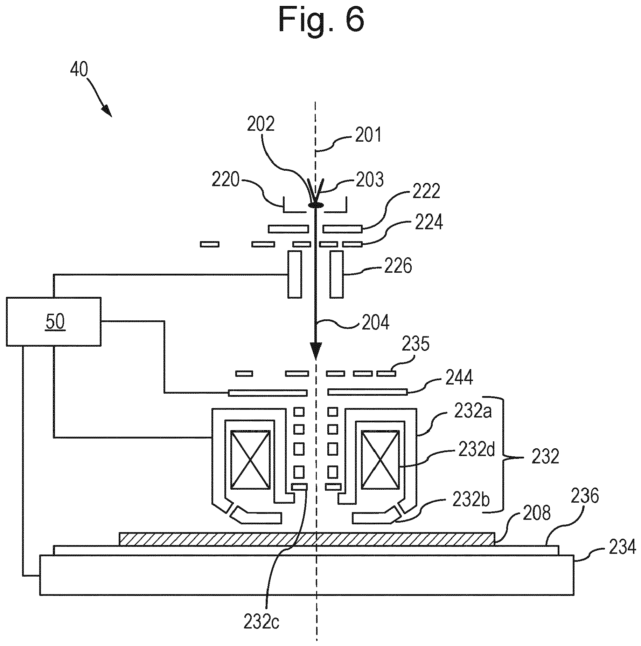

Reference is now made to Figure 6, which is a schematic diagram of an exemplary single beam electron-optical column 40 (also referred to as apparatus 40) of the inspection apparatus 100 of Figure 1. The electron-optical column 40 may comprise an electron emitter, which may comprise a cathode 203, an anode 220, and a gun aperture 222. The electron-optical column 40 may further include a Coulomb aperture array 224, a condenser lens 226, a beam-limiting aperture array 235, an objective lens assembly 232, and an electron detector 244. The electron-optical column 40 may further include a sample holder 236 supported by a motorized stage 234 to hold a sample 208 to be inspected. It is to be appreciated that other relevant components may be added or omitted, as needed.

In some embodiments, the electron emitter may include cathode 203, an extractor anode 220, wherein primary electrons can be emitted from the cathode and extracted or accelerated to form a primary electron beam 204 that forms a primary beam crossover 202 (virtual or real). The primary electron beam 204 can be visualized as being emitted from the primary beam crossover 202.

In some embodiments, the electron emitter, condenser lens 226, objective lens assembly 232, beam-limiting aperture array 235, and electron detector 244 may be aligned with a primary optical axis 201 of the apparatus 40. In some embodiments, the electron detector 244 may be placed off the primary optical axis 201, along a secondary optical axis (not shown).

Objective lens assembly 232, in some embodiments, may comprise a modified swing objective retarding immersion lens (SORIL), which includes a pole piece 232a, a control electrode 232b, a deflector 232c (or more than one deflector), and an exciting coil 232d. In a general imaging process, primary electron beam 204 emanating from the tip of cathode 203 is accelerated by an accelerating voltage applied to anode 220. A portion of primary electron beam 204 passes through gun aperture 222, and an aperture of Coulomb aperture array 224, and is focused by condenser lens 226 so as to fully or partially pass through an aperture of beam-limiting aperture array 235. The electrons passing through the aperture of beam-limiting aperture array 235 may be focused to form a probe spot on the surface of sample 208 by the modified SORIL lens and deflected to scan the surface of sample 208 by deflector 232c. Secondary electrons emanated from the sample surface may be collected by electron detector 244 to form an image of the scanned area of interest.

In the objective lens assembly 232, the exciting coil 232d and the pole piece 232a may generate a magnetic field that is leaked out through the gap between two ends of the pole piece 232a and distributed in the area surrounding the optical axis 201. A part of the sample 208 being scanned by the primary electron beam 204 can be immersed in the magnetic field and can be electrically charged, which, in turn, creates an electric field. The electric field may reduce the energy of the impinging primary electron beam 204 near and on the surface of the sample 208. The control electrode 232b, being electrically isolated from the pole piece 232a, controls the electric field above and on the sample 208 to reduce aberrations of the objective lens assembly 232 and control focusing situation of signal electron beams for high detection efficiency. The deflector 232c may deflect the primary electron beam 204 to facilitate beam scanning on the sample 208. For example, in a scanning process, the deflector 232c can be controlled to deflect the primary electron beam 204 onto different locations of the top surface of the sample 208 at different time points, to provide data for image reconstruction for different parts of the sample 208.

Backscattered electrons (BSEs) and secondary electrons (SEs) (which may be referred to collectively as signal electrons) can be emitted from the part of the sample 208 receiving the primary electron beam 204. The electron detector 244 may capture the BSEs and SEs and generate an image of the sample 208 based on the information collected from the captured signal electrons. If the electron detector 244 is positioned off the primary optical axis 201, a beam separator (not shown) can direct the BSEs and SEs to a sensor surface of the electron detector 244. The detected signal electron beams can form corresponding secondary electron beam spots on the sensor surface of the electron detector 244. The electron detector 244 can generate signals (e.g., voltages, currents) that represent the intensities of the received signal electron beam spots, and provide the signals to a processing system, such as the controller 50. The intensity of secondary or backscattered electron beams, and the resultant beam spots, can vary according to the external or internal structure of the sample 208. Moreover, as discussed above, the primary electron beam 204 can be deflected onto different locations of the top surface of the sample 208 to generate secondary or backscattered signal electron beams (and the resultant beam spots) of different intensities. Therefore, by mapping the intensities of the signal electron beam spots with the locations of the primary electron beam 204 on the sample 208, the processing system can reconstruct an image of the sample 208 that reflects the internal or external structures of the sample 208.

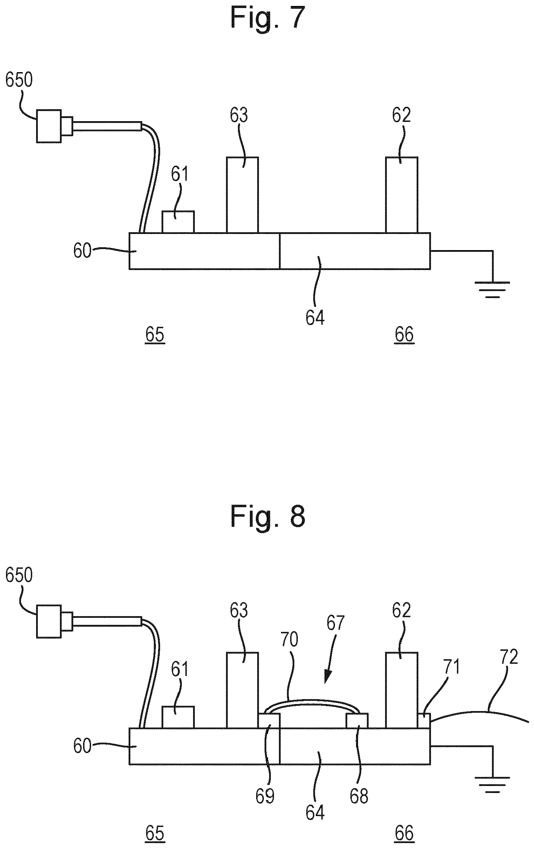

Figure 7 is a schematic diagram of part of an electron beam apparatus according to an embodiment of the invention. The electron beam apparatus is configured to project an electron beam towards the sample 208. The electron beam apparatus projects the electron beam through the electron-optical column 40.

In an embodiment the electron beam apparatus is an electron beam inspection apparatus 100 comprising a detector 240. Such a detector 240 is an example of an assembly configured to operate on electrons emitted from the sample 208 in response to the electron beam.

In an embodiment the electron beam apparatus comprises an electron-optical device configured to operate on the electron beam in a path of the electron beam towards the sample 208. In an embodiment the electron beam is an array of electron beams and the electron-optical device comprises an array of electron-optical elements corresponding to the array of electron beams. The array may be an array of multipole elements (e.g. multipole deflectors) configured to manipulate the electron beams. The array may be an array of electron-optical lensing elements. The lensing elements may comprise two or more electrodes arranged along the beam path and in each electrode may feature an aperture around a beamlet path. One or more electrodes may be common to two or more beamlet paths, if not all beamlet paths. Each beamlet path may have a corresponding aperture in an electrode or an aperture in an electrode may have a plurality of corresponding beamlet paths. Such an electron-optical device is an example of an assembly configured to operate on electrons in the electron beam path.

In an alternative embodiment the electron beam apparatus is a lithography apparatus. Such a lithography apparatus may not comprise a detector. Such a lithography apparatus may be a writing tool.

As mentioned above, in an embodiment the electron beam apparatus is a multi-beam apparatus, for example with a plurality of beamlets arranged in a beam arrangement. The beamlets may have defined positional relationships with other beamlets in the beam arrangement. In an alternative embodiment the electron beam apparatus is a single beam apparatus.

As shown in Figure 7, in an embodiment the electron beam apparatus comprises an electronic device 61. The electronic device 61 comprises active electronics. The electronic device 61 is configured to use energy to perform one or more functions. In an embodiment the electronic device 61 comprises an integrated circuit. The integrated circuit may use energy to perform one or more functions. In an embodiment the electronic device 61 comprises an amplifier such as a trans-impedance amplifier. The trans-impedance amplifier may be configured to amplify a measured signal of electrons emitted from the sample 208. The trans-impedance amplifier may be connected to the detector 240. In an embodiment the electronic device 61 comprises a PIN diode and/or a digital to analog converter (DAC). The PIN diode may be form part of the detector 240 or may even provide part of or indeed a detecting element. The DAC may be connected to the detector 240. For a multi-beam apparatus, the electronic device may comprise an array of elements which may be assigned to one or a group of the beamlets of the multi-beam or may be arranged with similar devices in an array, each device or group of devices in the array of devices being assigned to one or a group of the beamlets..

As shown in Figure 7, in an embodiment the electron beam apparatus comprises an power source 62 (which may also be called an energy source). The power source 62 is configured to output photonic radiation. The power source provides energy in the form of radiation. In an embodiment the radiation comprises optical light. In an embodiment the power source 62 comprises at least one LED. In an embodiment the power source 62 comprises an array of LEDs. In an alternative embodiment the power source 62 comprises a laser. The laser may be a semiconductor laser. Such a laser may be capable of outputting a greater power than a LED. In an embodiment the power source comprises an array of lasers.

As shown in Figure 7, in an embodiment the electron beam apparatus comprises an power converter 63 (which may also be called an energy converter). The power converter 63 is configured to receive radiation from the power source 62. The power converter 63 may comprise a radiation receiving surface for receiving radiation from the power source 62. The radiation receiving surface may face the power source 62.

In an embodiment the power converter 63 is configured to convert the received radiation into electricity (i.e. electrical power or electrical energy). In an embodiment the radiation receiving surface comprises at least one photosensor. Such a photosensor may be configured to detect the radiation for conversion into electrical energy. The power converter 63 may comprise a photovoltaic cell such as a solar cell. In an embodiment the power converter 63 is electrically connected to the electronic device 61. The power converter 63 is configured to output the electricity to the electronic device 61. The electronic device 61 uses the electricity to perform one or more functions. The power source 62 is configured to provide power to the electronic device 61 via the power converter 63.

In an embodiment the power source 62 is electrically isolated from the power converter 63. An embodiment of the invention is expected to reduce the possibility of electrical breakdown. An embodiment of the invention is expected to reduce the complexity of the mechanism that provides power to the electronic device 61. An embodiment of the invention is expected to reduce the amount of space taken up by the mechanism to provide power to the electronic device 61.

As shown in Figure 7, in an embodiment the electronic device 61 is provided in a high voltage region 65 of the electron beam apparatus. The high voltage region 65 is a region in which components are held at high voltage. As shown in Figure 7, in an embodiment a high voltage cable 650 is electrically connected to the electronic device 61. The term high voltage is used to mean that the potential difference relative to ground is at least 0.5kV. In an embodiment the potential difference to ground is at least 1kV, optionally at least 2kV, optionally at least 5kV, optionally at least 10kV, optionally at least 20kV and optionally at least 30kV. In an embodiment the potential difference to ground is at most 50kV.

A high voltage circuit board 60 may be provided in the high voltage region 65. The electronic device 61 may be connected to the high voltage circuit board 60. The electronic device 61 may be integrated into the high voltage circuit board 60. The electronic device 61 may be connected to the high voltage cable 650 via the high voltage circuit board 60. Alternatively the electronic device 61 may be connected to the high voltage cable 650 directly.

As shown in Figure 7, in an embodiment the power converter 63 is provided in the high voltage region 65. The power converter 63 may be connected to the high voltage circuit board 60. The power source 62 is provided in a low voltage region 66. The low voltage region 66 is a region in which electrical components are at a potential difference relative to ground of less than 100V, optionally less than 50V, optionally less than 20V and optionally less than 10V. The power source 62 and the power converter 63 are provided in regions/locations of the electron beam apparatus at different electrical potentials. A potential difference is provided between the power source 62 and the power converter 63. The potential difference may be at least 50V, optionally at least 100V, optionally at least 200V, optionally at least 500V, optionally at least 1kV, optionally at least 2kV, optionally at least 5kV, optionally at least 10kV, optionally at least 20kV, optionally at least 30kV and optionally at least 50kV.

In an embodiment a low voltage circuit board 64 is provided in the low voltage region 66. In an embodiment the power source 62 is connected to the low voltage circuit board 64. In an embodiment the low voltage circuit board 64 is connected to ground, for example as depicted.

The power source 62 and the power converter 63 are configured to provide optical energy transport for the electronic device 61 at high voltage. The invention is particularly applicable where part of the electron beam apparatus is required to be lifted to high voltage but also needs energy for active components. The electronic device 61 is such an active component that needs energy.

By transporting the energy optically, electrical isolation can be achieved without requiring a transformer-like solution which is bulky. By transporting the energy optically, the possibility of generating unwanted magnetic fields is reduced. Otherwise, a transformer-like solution can have stray magnetic fields that undesirably influence the electron beam. By transporting the energy optically, the there is greater design freedom for the materials used for the energy transport being vacuum compatible.

It should be noted that an electron-optical column is typically maintained within a vacuum environment. A vacuum chamber is provided around the electron-optical column. If a transformer were to be used proximate to the electron-optical column, it would have to be provided within the chamber which would be undesirable. Not only would there be unwanted magnetic fields proximate the electron-optical elements of the column, but the chamber would have to be larger and bulkier to contain the bulky transfer.

A solution to that problem is to have the transformer external to the column. Like any voltage, current or power supply the electrical connection would need to be through a feedthrough in the chamber wall while maintaining and without risk to the vacuum pressure. Such feedthroughs add complexity to the vacuum design and always bring risk to the integrity of the vacuum. Further, the electrical connection from the transfer to the electrical device would be at high voltage which requires additional measures to avoid unwanted discharged to maintain safety thereby increasing the volume required by the design and its complexity for example to the feedthrough such as disclosed in EP Application 20196493.9 filed on 16 September.

As shown in Figure 7, in an embodiment the high voltage circuit board 60 and the low voltage circuit board 64 are different parts of the same substrate. The power source 62 is connected to a substrate and the power converter 63 is connected to the substrate. The portions of the substrate to which the power source 62 and the power converter 63 are connected are electrically isolated from each other. Alternatively, the high voltage circuit board 60 and the low voltage circuit board 64 may be provided as physically separate substrates.

Figure 8 is a schematic diagram of part of an electron beam apparatus according to an embodiment of the invention. Features of the arrangement of Figure 8 that are also shown in Figure 7 are not described below for conciseness.

As shown in Figure 8, in an embodiment the electron beam apparatus comprises a control signal emitter 68. The control signal emitter 68 is configured to radiate photonically a control signal. In an embodiment the control signal emitter 68 is provided in the low voltage region 66. The control signal emitter 68 may be connected to the low voltage circuit board 64. Alternatively, the control signal emitter 68 may be connected to a separate circuit board. The control signal may be a control signal for controlling the electronic device 61. For example the control signal may be for controlling the electronic device 61 to switch on, to switch off, to operate in a particular mode or to operate according to a particular setting. The control signal emitter 68 is configured to emit the control signal in the form of radiation. In an embodiment the control signal emitter 68 is connected to the controller 50. The controller 50 is configured to control the control signal emitted by the control signal emitter 68.

As shown in Figure 8, in an embodiment the electron beam apparatus comprises a control signal photosensor 69. The control signal photosensor 69 is configured to receive the radiated control signal. In an embodiment the control signal photosensor 69 is configured to convert the radiated control signal into an electrical control signal. In an embodiment the control signal photosensor 69 is configured to output the electrical control signal to control the electronic device 61. In an embodiment the control signal photosensor 69 is provided in the high voltage region 65. In an embodiment the control signal photosensor 69 is connected to the high voltage circuit board 60. Alternatively, the control signal photosensor 69 may be connected to a separate circuit board.

In an embodiment the control signal emitter 68 is electrically isolated from the control signal photosensor 69. An embodiment of the invention is expected to allow for signal transfer from the low voltage region 66 to the high voltage region 65.

In an embodiment, the control signal emitter 68 is coupled to a suitable waveguide such as an optical fiber 70. The control signal emitter 68 is configured to emit the control signal through the optical fiber 70. The waveguide, for example the optical fiber 70, is configured to direct the control signal to, and for example is coupled to, the control signal photosensor 69. An embodiment of the invention is expected to reduce loss in the control signal. In an embodiment the control signal emitter 68 and the control signal photosensor 69 are transceivers configured to send and receive control signals. In an embodiment the control signal emitter 68 and the control signal photosensor 69 are comprised in an optocoupler 67. An optocoupler 67 is a relatively cheap off-the-shelf component. An embodiment of the invention is expected to reduce the complexity of the mechanism for controlling the electronic device 61 in the high voltage region 65. An embodiment of the invention is expected to reduce the cost of manufacturing the mechanism for controlling the electronic device 61 in the high voltage region 65.

In an embodiment the control signal path is separate from the power/energy provision path. The power source 62 may be separate from the control signal emitter 68. The power converter 63 may be separate from the control signal photosensor 69.

In an embodiment the electron beam apparatus comprises a data signal emitter. In an embodiment the data signal emitter and the control signal receiver 69 are provided by a light transceiver. The light transceiver is configured to send and receive light signals. Alternatively, the data signal emitter may be provided as a separate component from the control signal receiver 69.

The data signal emitter is configured to radiate photonically a data signal. In an embodiment the data signal emitter is provided in the high voltage region 65. The data signal emitter may be connected to the high voltage circuit board 60. Alternatively, the data signal emitter may be connected to a separate circuit board. The data signal may be a data signal from the electronic device 61. For example the data signal may comprise information measured by or detected by the electronic device 61. The data signal is based on data received from the electronic device 61. The data signal emitter is configured to emit the data signal in the form of radiation.

In an embodiment the electron beam apparatus comprises a data signal photosensor. In an embodiment the data signal photosensor and the control signal emitter 68 are provided by a light transceiver. The light transceiver is configured to send and receive light signals. Alternatively, the data signal photosensor may be provided as a separate component from the control signal emitter 68.

The data signal photosensor is configured to receive the radiated data signal. In an embodiment the data signal photosensor is configured to convert the radiated data signal into an electrical data signal. In an embodiment the data signal photosensor is configured to output the electrical data signal for processing and/or storage. In an embodiment the data signal photosensor is provided in the low voltage region 66. In an embodiment the data signal photosensor is connected to the low voltage circuit board 64. Alternatively, the data signal photosensor may be connected to a separate circuit board.

In an embodiment the data signal emitter is electrically isolated from the data signal photosensor. An embodiment of the invention is expected to allow for signal transfer from the high voltage region 65 to the low voltage region 66. In an embodiment the data signal emitter is at a location of elevated potential relative to the location of the data signal photosensor. In an alternative embodiment (e.g. when the electron beam apparatus is a lithography apparatus), the data signal photosensor is at a location of elevated potential relative to the location of the data signal emitter.

In an embodiment, the data signal emitter is coupled to a suitable waveguide such as an optical fiber 70. The data signal emitter is configured to emit the data signal through the optical fiber 70. The waveguide, for example the optical fiber 70, is configured to direct the data signal, for example is connected, to the data signal photosensor. An embodiment of the invention is expected to reduce loss in the data signal. In an embodiment the data signal emitter and the data signal photosensor are transceivers configured to send and receive data signals. In an embodiment the data signal emitter and the data signal photosensor are comprised in an optocoupler 67. In an embodiment the data signal transfer and the control signal transfer are performed by the same optocoupler 67. An embodiment of the invention is expected to reduce the complexity of the mechanism for transferring data from the electronic device 61 in the high voltage region 65. An embodiment of the invention is expected to reduce the cost of manufacturing the mechanism for reading out data from the electronic device 61 in the high voltage region 65. As shown in Figure 8, in an embodiment a data line 72 is provided for transmitting data downstream for further processing, for example through the vacuum chamber wall, for example through a feedthrough. Note the data line 72, or a different control line from outside the vacuum (i.e. from outside the vacuum chamber wall), may be coupled to the control signal emitter 68.

In an embodiment the data signal path is separate from the power/energy provision path. The power source 62 may be separate from the data signal emitter. The power converter 63 may be separate from the data signal photosensor.

Data may be transmitted in either direction. In an embodiment the method comprises transmitting the data signal between the electronic device 61 and data signal emitter or the data signal photosensor. In an embodiment the method comprises transmitting data signals to and from the electronic device 61 wherein the data signal comprises an inbound data signal to the electronic device 61 and an outbound data signal from the electronic device 61.

As described above, in an embodiment the power for the electronic device is emitted from the power source 62 to the power converter 63. The power may be transmitted optically through the environment without any waveguide such as an optical fiber. A greater proportion of the radiation receiving surface of the power converter 63 can be used to receive radiation without being limited to parts of the surface coupled to a waveguide. An embodiment of the invention is expected to allow a greater amount of power to be transferred optically.

In an alternative embodiment at least one waveguide may be provided for transporting the energy from the power source 62 to the power converter 63. The waveguide may reduce the loss of energy. For example, a LED or laser as the power source 62 may be coupled to an optical fiber, the other end of which is coupled to the power converter. In an embodiment a plurality of waveguide are provided to transfer energy from the power source 62 to the power converter 63. A greater number of waveguides allows a greater power to be transferred. An array of waveguides couple to an array of LEDs or lasers at one end and photosensors at the other end may be provided. Use of waveguides may also permit the direct line of sight between the power source 62 and power converter 63 to be obstructed. This may permit more design freedom in a constrained space.

As described above, in an embodiment control signals and/or data signals are transported through one or more optical fibers 70. An optical fiber 70 allows the control signals and/or data signals to be transferred between the high voltage region 65 and the low voltage region 66 while maintaining a galvanic separation. A different type of connection with a galvanic separation may be used. In an alternative embodiment the control signals are transferred without the optical fiber 70. In an alternative embodiment the data signals are transferred without the optical fiber 70.

In an embodiment there is provided a method of using an electron beam apparatus. The method comprises projecting an electron beam towards the sample 208. In an embodiment the method comprises operating on the electron beam either in the electron beam path or emitted from the sample 208 in response to the electron beam. In an alternative embodiment this operating step is not performed. For example, when the electron beam apparatus is a writing tool, it may not be necessary to detect electrons emitted from the sample 208.

The method comprises outputting photonic radiation from the power source 62. The method comprises receiving the photonic radiation at the power converter 63. The method comprises converting the photonic radiation into electricity and outputting the electricity to the electronic device 61 of the electron beam apparatus. As mentioned above, the power source 62 is electrically isolated from the power converter 63.

In an embodiment an integrated circuit and/or a trans-impedance amplifier of the electronic device 61 are powered with the electricity. In an alternative embodiment the electronic device 61 does not comprise such an integrated circuit or trans-impedance amplifier.

The present invention may be embodied as a computer program. For example, a computer program may comprise instructions to instruct the controller 50 to perform the following steps. The controller 50 controls the electron beam apparatus to project an electron beam towards the sample 208. In an embodiment the controller 50 controls at least one electron-optical element (e.g. an array of multipole deflectors) to operate on the electron beam in the electron beam path. Additionally or alternatively, in an embodiment the controller 50 controls at least one electron-optical element (e.g the detector 240) to operate on the electron beam emitted from the sample 208 in response to the electron beam.

The controller 50 controls the power source 62 to output photonic radiation. The controller 50 controls the power converter 63 to convert the photonic radiation into electricity and output the electricity to the electronic device 61 of the electron beam apparatus.

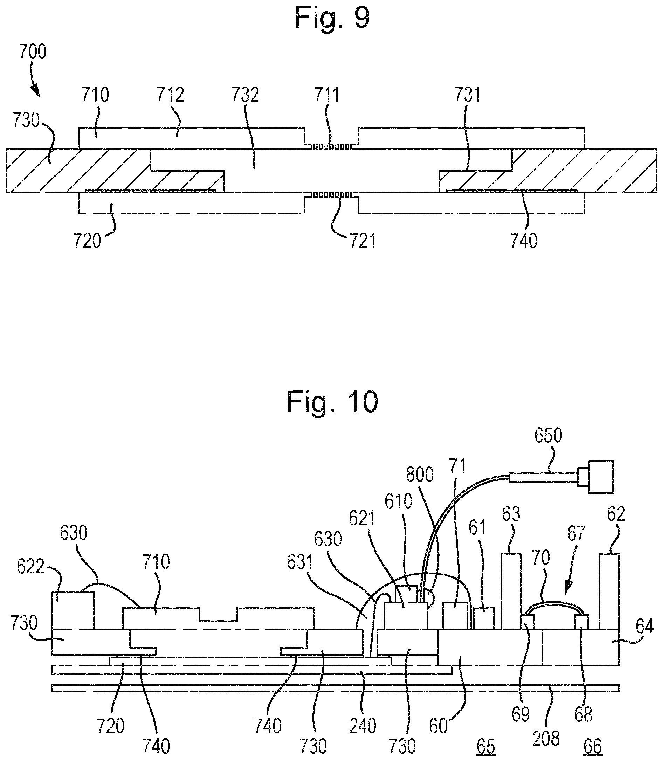

Figure 9 is a schematic diagram of an electron-optical device 700 of the electron beam apparatus according to an embodiment of the invention. In an embodiment the electron beam apparatus comprises an electron-optical column 40 configured to generate beamlets from a source beam and to project the beamlets towards the sample 208. In an embodiment, at least part of the electron-optical column 40 is configured to operate at a potential difference of at least 50V, optionally at least 100V, optionally at least 200V, optionally at least 500V, optionally at least 1kV from ground.

The exemplary arrangement shown in Figure 9 comprises an array substrate 710, an adjoining substrate 720 and a spacer 730. (Note the term 'array substrate' is a term used to differentiate the substrate from other substrates referred to in the description). In the array substrate 710, an array of apertures 711 is defined for the path of electron beamlets. The number of apertures in the array of apertures 711 may correspond to the number of sub-beams in the multi-beam arrangement. The array substrate 710 may have a thickness which is stepped such that the array substrate 710 is thinner in the region corresponding to the array of apertures 711 than another region 712 of the array substrate 710. In one arrangement there are fewer apertures than sub-beams in the multi-beam so that groups of sub-beam paths pass through an aperture. For example an aperture may extend across the multi-beam path; the aperture may be a strip or slit. The spacer 730 is disposed between the substrates 710, 720 to separate the substrates 710, 720. A potential difference is provided between the array substrate 710 and the adjoining substrate 720.

In the adjoining substrate 720, another array of apertures 721 is defined for the path of the electron beamlets. The spacer 730 and the adjoining substrate 720 may have a thickness which is stepped to be thinner in the region corresponding to the array of apertures 721 than another region. Preferably, the array of apertures 721 defined in the adjoining substrate 720 has the same pattern as the array of apertures 711 defined in the array substrate 710. In an arrangement the pattern of the array of apertures in the two substrates may be different. For example, the number of apertures in the adjoining substrate 720 may be fewer or greater than the number of apertures in the array substrate 710. In an arrangement there is a single aperture in the adjoining substrate for all the paths of the sub-beams of the multi-beam. Preferably the apertures in the array substrate 710 and the adjoining substrate 720, are substantially mutually well aligned. This alignment between the apertures is in order to limit lens aberrations

A coating may be provided on a surface of the array substrate 710 and/or the adjoining substrate 720. Preferably both the coating is provided on the array substrate 710 and the adjoining substrate 720. The coating reduces surface charging which otherwise can result in unwanted beam distortion.

The array substrate 710 and/or the adjoining substrate 720 may comprise a low bulk resistance material, preferably a material of 1 Ohm.m or lower. More preferably, the array substrate 710 and/or the adjoining substrate 720 comprises doped silicon. Substrates having a low bulk resistance have the advantage that they are less likely to fail because the discharge current is supplied/drained via the bulk and not, for example, via the thin coating layer.

One of the array substrate 710 and the adjoining substrate 720 is upbeam of the other. One of the array substrate 710 and the adjoining substrate 720 is negatively charged with respect to the other substrate. Preferably the upbeam substrate has a higher potential than the downbeam substrate with respect to for example to a ground potential, the source or of the sample 208. A potential difference of 5 kV or greater ay be provided between the array substrate 710 and the adjoining substrate 720. Preferably, the potential difference is 10 kV or greater. More preferably, the potential different is 20 kV or greater.

The spacer 730 is preferably disposed between the array substrate 710 and the adjoining substrate 720 such that the opposing surfaces of the substrates are co-planar with each other. The spacer 730 has an inner surface 731 facing the path of the beamlets. The spacer 730 defines an opening 732 for the path of the electron beamlets. The spacer 730 is electrically isolating. The spacer 730 may electrically isolate the array substrate 710 and the adjoining substrate 720 and may comprise ceramic or glass.

A conductive coating 740 may be applied to the spacer 730. Preferably, a low ohmic coating is provided, and more preferably a coating of 0.5 Ohms/square or lower is provided.

The coating 740 is preferably on the surface of the space facing the negatively charged substrate, which is negatively charged with respect to the other substrate. The downbeam substrate is preferably negatively charged with respect to the upbeam substrate. The coating 740 shall be put at the same electric potential as the negatively charged substrate. The coating 740 is preferably on the surface of the spacer facing the negatively charged substrate. The coating 740 is more preferably electrically connected to the negatively charged substrate. The coating 740 can be used to fill any possible voids in between the spacer 730 and the negatively charged substrate.

In an embodiment the electronic device 61 is provided in a lens assembly for manipulating electron beamlets. In an embodiment the electronic device 61 is provided in a region (i.e. a location of the electron-optical column 40) in which the electron-optical column 40 is configured to operate at a potential difference of at least 50V, optionally at least 100V, optionally at least 200V, optionally at least 500V, optionally at least 1kV from ground. The lens assembly may, for example, be, or may be part of, an objective lens assembly as depicted in Figure 9 or a condenser lens assembly. The lens assembly, such as an objective lens assembly, may further comprise an additional lens array comprising at least two substrates such as a control lens array.

As shown in Figure 10, the lens assembly may comprise a protective resistor 610. The protective resistor 610 may be located in electrical routing, such as a power line, connecting a substrate, such as the upbeam or downbeam substrate, to a power source. The electrical routing may provide a potential to the substrate. The protective resistor 610 may be configured to provide controlled discharge in the lens of capacitance in a power line. The protective resistor 610 therefore prevents damage to the lens assembly.

Further, in the lens assembly, signal communication may be provided to enable data transport to and from the lens assembly specifically elements of the lens assembly such as a substrate, e.g. the upbeam substrate or the downbeam substrate, or the detector 240. The detector 240 may be a detector array.

As shown in Figure 10, in an embodiment the protective resistor 610 is electrically connected to a first circuit board 621 electrically connected to the adjoining substrate 720 for example via a connector 630. The first circuit board 621 may comprise a material, such as a ceramic, having good dielectric strength and thermal conductance with low outgassing in the vacuum environment. The lens assembly may comprise a connector configured to electrically connect the array substrate 710 and/or the adjoining substrate 720 to the first circuit board 621. In an arrangement the protective resistor 610 may be an integral element of the first circuit board 621.

As shown in Figure 10, in an embodiment the lens assembly further comprise a second circuit board 622 electrically connected to the array substrate 710 for example by a connector such as a connecting wire. A high voltage cable 650 is electrically connected to the first circuit board 621. The connection may be made using a connection material 800, such as solder. The cable 650 provides a means of applying a potential to the substrate, for example the adjoining substrate 720. In certain designs the potential may be applied to the whole substrate, to different elements in the substrate with different potentials and dynamically either to the whole substrate or elements within the substrate. The second circuit board 622 and the upbeam substrate 710 may be connected to the high voltage cable 650. The cable 650 may in addition transmit data to and/or from the lens assembly.

The exemplary lens assembly of Figure 10, comprises a connector 630 to electrically connect the adjoining substrate 720 to the first circuit board 621. The connector 630 is surrounded by an electrically insulating material 631. The insulating material 631 may have a dielectric strength of 25 kV/mm or greater, preferably 100 kV/mm or greater, and more preferably 200 kV/mm or greater. The use of electrically insulating material reduces the occurrence of discharge events.

The connector 630 may be a wire and may form a wire bond connection. The spacer 730 may define a connection opening through which the connector 630 can pass, for example to connect to the adjoining or downbeam substrate. Thus, the first circuit board 621 and/or the protective resistor 610 may be provided on an opposite side of the spacer 730 than the adjoining substrate 720. The insulating material 631 may fill the connector opening in the spacer 730. In an arrangement the protective resistor may be in, for example as an integral element of, the first circuit board.

Although Figure 10 shows an objective lens assembly, these features may be comprised in another lens assembly such as a condenser lens assembly. Such a lens assembly may feature a lens array such as condenser lens array 231 as shown in and described with respect to Figure 5 and Figure 6.

As shown in Figure 10, in an embodiment the lens assembly comprises a detector comprised within a detector device 240 which may take the form of a substrate or plate. The detector may take the form of an array at a portion of the detector device 240 corresponding with the beam path (not shown) and as later described. The detector device 240 may be comprised in a detector assembly. The detector assembly may comprises the electronic device 61. Alternatively, the electronic device 61 may comprise the detector and optionally components of the detector device 240 . In an embodiment the detector assembly is integrated in an objective lens assembly configured to focus the electron beam on the sample 208. The detector may comprise silicon and preferably the detector substantially comprises silicon, as may the detector device 240 (in comprising silicon and in preferably substantially comprising silicon). The detector as a detector array, for example of detector elements, may be configured to detect signal electrons emitted from the sample 208. A detector element may be associated with each sub-beam path. The detector array may take the form and function of a detector array described and depicted in 2019P00407EP filed in July 2020, such detector arrays described therein hereby incorporated by reference with respect the form of the different detector arrays. Preferably at least portion of the detector is adjacent to and/or integrated with the objective lens array; for example the detector array be adjacent or integral to the adjoining substrate 720. In an arrangement in which the detector adjoins the adjoining substrate 720, the planar detector device in which the detector is comprised may be secured to the adjoining substrate 720.

In the arrangement depicted in Figure 10, the detector array is electrically connected via the adjoining substrate 720. Thus the detector array is signally connected via the adjoining substrate 720. The detector array may therefore be connected via the first circuit board 621 (which may be ceramic), the connector 630 and the cable 650.

In the arrangement depicted in Figure 10 the detector assembly may comprise a high voltage circuit board 60 (which is also be referred to herein as a detection circuit board). The detection circuit board is electrically connected to the detector array. In Figure 10, the adjoining substrate 720 is electrically connected to the first circuit board 621 and the detector array is connected to the detection circuit board. Alternatively, one of the circuit boards may be electrically connected to both the adjoining substrate 720 and detector array. For example the high voltage circuit board 60 may be electrically coupled preferably connected to the detector device 240. The detector device 240 may be spaced away from the adjoining substrate 720 by a small gap. The detector device 240 may not in direct electrical contact with the adjoining substrate 720.

The detector assembly may comprise ceramic. Preferably the detector assembly comprises a ceramic material in the detection circuit board. More preferably the detection circuit board comprises a ceramic circuit board.

As shown in Figure 10, in an embodiment the electron beam apparatus comprises a thermal conditioner 71. At least part of the lens assembly, such as an objective lens assembly may be thermally conditioned. Thus elements of the objective lens assembly such as the upbeam substrate, the downbeam substrate and the detection assembly may be thermally conditioned. Thus the detector, the detector device and the detection circuit board may be thermally conditioned. In an embodiment the thermal conditioner 71 is configured to thermally condition the high voltage circuit board 60. In an embodiment the high voltage circuit board 60 is made of a thermally conductive material. The thermal conditioner 71 thermally conditions the electronic device 61 via the high voltage circuit board 60. As the detector comprises active electronics it may generate heat. Because the detector is a heat source, it is preferable to space the detector device 240 from the adjoining substrate 720. The risk of the detector heating the adjoining substrate 720 may be reduced. Preferably, thermal conditioning may be achieved actively by cooling. The detection circuit board may be actively cooled. If the detection circuit board comprises a ceramic, cooling of the detection circuit can also cool other parts of the objective lens assembly through the thermal conductance of elements of the objective lens assembly comprising materials of high thermal conductivity such as ceramic. For an arrangement in which the detector device 240 is spaced away from the adjoining substrate 720, the active cooling of the detector device 240 via the detection circuit board may assist in suppressing any heat load applied by the detector device 240 to the adjoining substrate 720. Other parts of the objective lens assembly which may be cooled include the detector assembly, one or both of the array substrate 710 and the adjoining substrate 720 as well as the first and second circuit boards 621, 622 which may each comprise ceramic material (thereby facilitate the thermal conditioning and thus cooling). In cooling the detector assembly the detector device 240, detector and its detector elements may be cooled due to thermal conductivity through the detection circuit board. In another arrangement the detector device 240 optionally the detector is actively cooled in addition or in alternate to the active thermal conditioning of the detection circuit board.

As shown in Figure 10 , an power source 62 is provided in the low voltage region 66. The power source 62 is configured to output radiation. In an embodiment an power converter 63 is provided in the high voltage region 65. The power converter 63 may be connected to the detection circuit board. The power converter 63 is configured to receive radiation from the power source 62, to convert the received radiation into electricity and to output the electricity to the electronic device 61. The power source 62 is electrically isolated from the power converter 63.

In an embodiment the electronic device 61 comprises or is a chip configured to read out data from the detector 240. The chip may be a detector chip integrated with the detector 240. The detector chip may be in the beam path. The detector chip may be electrically connected to the power converter 63 via the high voltage circuit board 60 which is in electrical contact with the detector 240. The detector chip may be signally connected to the control signal photosensor 69 via the high voltage circuit board 60 which is in communication with the detector 240. In an embodiment the electronic device 61 comprises at least one circuit element such as an amplifier which requires electricity to function. The amplifier is in data communication with the detector 240. In an embodiment, the amplifier is in data communication with one of the detector elements of the detector 240.

Connections to transmit signals to or from the detector may be provided via electrical connection or glass fiber for data transport. By being electrically insulating, a glass fibre connection enables detector control and data processing at ground potential. Thus, less insulation material is required for signal communication via glass fiber than via an electrical connection. For example, a glass fiber connection may be provided to transport data to/from the detection circuit. As shown in Figure 10, in an embodiment an optocoupler 67 may be provided to transport signals from the detection circuit board. The optocoupler 67 may be fitted to the detection circuit board for connection to an optical fiber, for example a glass fiber.

As shown in Figure 10, in an embodiment the detection circuit board is configured to transmit and/or receive signal communication via an optic fiber 70. The downbeam substrate is in electrical connection with the first circuit board 621 via an insulated wire 630. Thus, the objective lens has signal communication via the optic fiber 70, in connection with the detector array, and via the cable 650, in connection with the downbeam substrate.

The detector 240 may form part of an election-optical column, such as the electron-optical column 40 of any of Figures 1 to 6. The electron-optical column 40 may be configured to generate beamlets from a source beam and to project the beamlets towards a sample 208. The detector 240 may be disposed facing the sample 208 and be configured to detect electrons emitted from the sample 208. The detector 240 may comprise an array of current detectors. Signal communication to the detector array may comprise signal communication via optic fiber which may be comprised in the objective lens assembly. An electron-optical system may comprise the electron-optical column 40. The electron-optical system may also comprise a source 201 configured to emit an electron beam.

The invention may have other applications within in an electron-optical column or an apparatus comprising an electron-optical column. These applications are located at a high power region and require a power signal or a data supply from a low voltage region. There may be a pressure differential between the high and low voltage regions, for example the regions may be either side of a vacuum chamber wall.

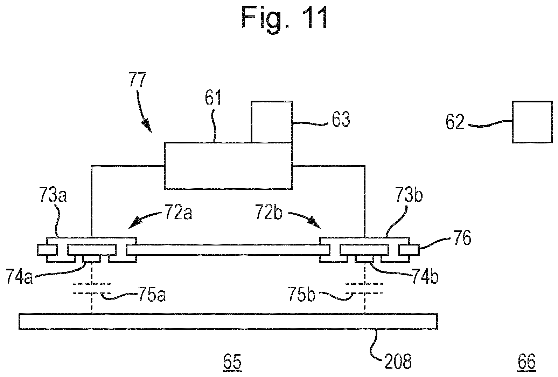

Figure 11 is a schematic diagram of part of an electron beam apparatus according to an embodiment of the invention. As shown in Figure 11 in an embodiment the electron beam apparatus comprises a capacitive sensor 77. The capacitive sensor 77 is configured to measure a distance from a reference point such as a surface. In the arrangement shown in Figure 11, the reference point is the top surface of the sample 208. Alternatively, the reference point may be the stage or another part of the electron beam apparatus for example facing the capacitive sensor. In an embodiment the capacitive sensor 77 is connected to an electron-optical assembly of the electron-optical column 40. The capacitive sensor 77 is configured to measure the distance such as the height of the electron-optical assembly above the sample 208, for example.

In an embodiment the capacitive sensor 77 comprises the electronic device 61. The capacitive sensor 77 is in a high voltage region 65 of the electron beam apparatus. The capacitive sensor 77 operates to sense a distance in a vacuum pressure environment. The capacitive sensor 77 is within a vacuum chamber defining the vacuum. The power source 62 powers the capacitive sensor 77 from the low voltage region 66. The low voltage region may be in a relatively higher pressure environment for example the ambient environment.

In an embodiment the power converter is electrically connected to the electronic device 61. In an embodiment the power converter 63 and the electronic device 61 are integrated into the same circuit board (not shown). In an embodiment the power source 62 is integrated into the same circuit board. Alternatively, the power source 62 may be provided on a different circuit board. In an embodiment the electronic device comprises or is a chip comprising electrical components.

In an embodiment the capacitive sensor 77 is configured to use differential measurement with high impedance amplifier circuits. The differential measurement with high impedance amplifier circuits may be comprised in whole or in part on the chip of the electronic device 61. As shown in Figure 11, in an embodiment the capacitive sensor 77 comprises two sensors 72a, 72b arranged in a differential pair. The sensing electrode 74a of sensor 72a and the sensing electrode 74b of sensor 72b are driven by AC current sources. In an embodiment the electronic device 61 comprises the two current sources. In an embodiment the current sources are 180 degrees out of phase to each other. During one half cycle, a current flows in one direction through sensor 72a and the sensor-to-target capacitance 75a, through the sample 208, and through the sensor-to-target capacitance 75b and through sensor 72b. During the next half cycle the current flows in the reverse direction.

In an embodiment amplifiers/buffers amplify the raw output voltages of the sensor 72a, 72b to generate respective output measurement signals for further processing. The output may also be fed back to the guard electrodes 73a, 73b. In an embodiment the guard electrodes 73a, 73b are mounted on an insulating layer 76. The measurement signals may be input to synchronous detector circuits respectively. In an embodiment the electronic device 61 comprises the amplifiers/buffers. In an embodiment a thermal conditioner is configured to thermally condition the capacitive sensor 77.

In an embodiment the capacitive sensor 77 is proximate a position of the sample 208. In an embodiment the capacitive sensor 77 faces the sample 208. In an embodiment the capacitive sensor 77 is associated with a portion of the electron-optical column 40 proximate the sample 208. In an embodiment the capacitive sensor 77 is located on the portion of the electron-optical column 40 proximate the sample 208.

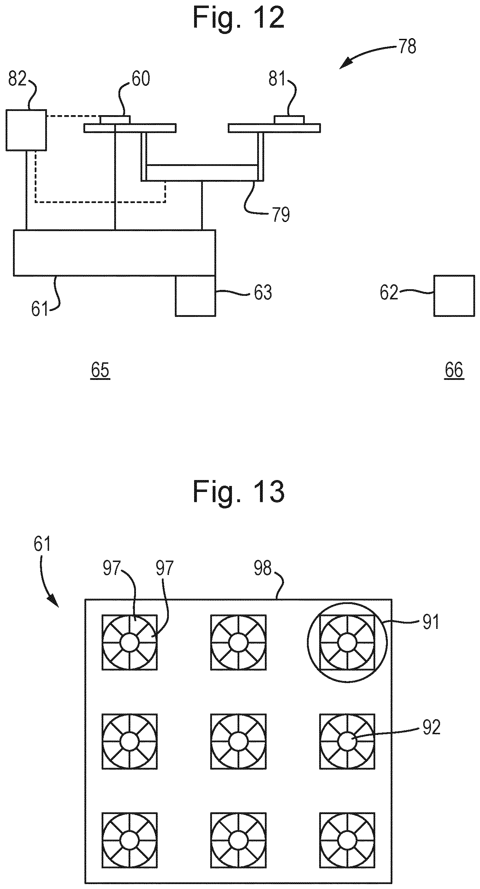

Figure 12 is a schematic diagram of part of an electron beam apparatus according to an embodiment of the invention. As shown in Figure 12 in an embodiment the electron beam apparatus comprises a sensor such as a beam measurement sensor 78 which may be located on or comprise part of the stage for supporting the sample 208. In an embodiment the beam measurement sensor 78 comprises the electronic device 61. The beam measurement sensor 78 is in a high voltage region 65 of the electron beam apparatus. In an embodiment the measurement sensor 78 is provided downbeam of the electron source 201. For example, the beam measurement sensor 78 may be connected to the beam former array 372 or a beam-limiting aperture array 321 of the electron-optical column 40 shown in Figure 2. Alternatively, the beam measurement sensor 78 may be connected to the upper beam limiter 252 or the beam shaping limiter 242 of the electron-optical column 40 shown in Figure 3 or a beam limiting aperture array associated with condenser lens array 231 of the arrangement show in Figure 5. Alternatively, the beam measurement sensor 78 may be connected to another component or provided independently of the components shown in Figures 2 and 3, for example. The power source 62 powers the beam measurement sensor 78 from the low voltage region 66.

As mentioned above, in an embodiment the electron beam apparatus comprises a stage for supporting the sample 208. In an embodiment the sensor such as the beam measurement sensor 78 is in the stage. In an embodiment the sensor such as the beam measurement sensor 78 is orientated facing in a direction towards the electron-optical column 40. In an embodiment the beam measurement sensor 78 is in a surface of the stage. In an embodiment the sensor, e.g. the beam measurement sensor 78, is facing away from the position of the sample 208.

In an embodiment the beam measurement sensor 78 is configured to measure properties such as a current of the electron beam(s). In an embodiment the beam measurement sensor 78 comprises a beam measurement controller 82. In an embodiment the beam measurement sensor 78 comprises a series of beam property sensors 79, 80, 81.

In this example, the series of beam property sensors comprises a central sensor 79 which comprises a Faraday cup. When all beamlets are deflected into the central sensor 79, the total current of the electron beamlets is measured. A measuring signal of the measurement of the central sensor 79 is directed to the beam measurement controller 82 and can be displayed, stored and/or further evaluated in the beam measurement controller 82.

In addition, the central censor 79 may be surrounded by several individual sensors 80, 81 for measuring beam properties of individual beamlets. In order to measure the beam properties of an individual beamlet, the individual beamlet is deflected onto one of the individual sensors 80, 81. A measuring signal of the measurement of the individual sensors 80, 81 is directed to the beam measurement controller 82 and can be displayed, stored and/or further evaluated in the beam measurement controller 82.

In an embodiment one or more of the beam measurement controller 82, the central sensor 79 and the individual sensors 80, 81 requires energy to function. As shown in Figure 12, in an embodiment the electronic device 61 is connected to one or more of the beam measurement controller 82, the central sensor 79 and the individual sensors 80, 81. In an embodiment the electronic device 61 comprises one or more of the beam measurement controller 82, the central sensor 79 and the individual sensors 80, 81. In an embodiment a thermal conditioner is configured to thermally condition the beam measurement sensor 78.

Figure 13 is a schematic diagram of an electronic device 61 according to an embodiment of the invention. In the example shown in Figure 13, the electronic device 61 comprises a manipulator device configured to manipulate electron beamlets that are projected towards the sample 208. In an embodiment the manipulator device 20 comprises a planar substrate 98. The planar substrate 98 is provided with an array of through openings 92. In an embodiment the through openings 92 are regularly arranged in rows and columns which may be angled relative to each other, for example in a rectilinear or hexagonal arrangement. In an alternative embodiment the through openings 92 are irregularly arranged. The through openings 92 are arranged for passage of a respective electron beamlet through it. Each through opening 92 is provided with a plurality of electrodes 97. The electrodes 97 may surround the through opening 92. Each through opening 92 with its electrodes 97 forms an individual multipole deflector 91 for example for deflecting the beamlets. In use the multipole deflector 91 is provided with an adjustable voltage for individually adjusting a trajectory or path of beamlets which traverse one of the through openings 92, for example for providing astigmatic correction for each individual beamlet. As shown in Figure 13, in an embodiment each multipole deflector 91 is provided with eight electrodes. However, the number of electrodes can be fewer than eight or more than eight for example 10, 12 or 20.

The manipulator device of the electronic device 61 comprises an array of electrostatic multipole deflectors 91, for example for correcting any astigmatism of the beamlets. The array of multipole deflectors 91 is in a high voltage region 65 for example the substrate on which the multipole deflectors 91 are depicted. The array of multipole deflectors 91 is powered by the power source 62 from a low voltage region 66 for example away from the substrate. In an embodiment a thermal conditioner is configured to thermally condition the array of multipole deflectors 91.

The array of multipole deflectors 91 may be part of the electron beam apparatus of any of the embodiments of the invention. For example, in an embodiment the array of multipole deflectors 91 is positioned between the upper beam limiter 252 and the beam shaping limiter 242 of the electron-optical column 40 shown in Figure 3. In an alternative embodiment the array of multipole deflectors 91 is positioned between the condenser lens array 231 and the detector 240 of the electron-optical column 40 shown in Figure 5. In an alternative embodiment the array of multipole deflectors 91 is comprised in the source converter 320 of the electron-optical column 40 shown in Figure 2.

A plurality of electron-optical systems may be comprised in an electron-optical system array. The electron-optical systems of the electron-optical system array are preferably be configured to focus respective multi-beams simultaneously onto different regions of the same sample 208.

Reference to a component or system of components or elements being controllable to manipulate a charged particle beam in a certain manner includes configuring a controller or control system or control unit to control the component to manipulate the charged particle beam in the manner described, as well optionally using other controllers or devices (e.g. voltage supplies and or current supplies) to control the component to manipulate the charged particle beam in this manner. For example, a voltage supply may be electrically connected to one or more components to apply potentials to the components, such as in a non-limited list the control lens array 250, the objective lens array 241, the condenser lens 231, correctors, collimator element array 271 and scan deflector array 260, under the control of the controller or control system or control unit. An actuatable component, such as a stage, may be controllable to actuate and thus move relative to another components such as the beam path using one or more controllers, control systems, or control units to control the actuation of the component.

The embodiments herein described may take the form of a series of aperture arrays or electron-optical elements arranged in arrays along a beam or a multi-beam path. Such electron-optical elements may be electrostatic. In an embodiment all the electron-optical elements, for example from a beam limiting aperture array to a last electron-optical element in a sub-beam path before a sample, may be electrostatic and/or may be in the form of an aperture array or a plate array. In some arrangements one or more of the electron-optical elements are manufactured as a microelectromechanical system (MEMS) (i.e. using MEMS manufacturing techniques).

References to upper and lower, up and down, above and below should be understood as referring to directions parallel to the (typically but not always vertical) up-beam and down-beam directions of the electron beam or multi-beam impinging on the sample 208. Thus, references to up beam and down beam are intended to refer to directions in respect of the beam path independently of any present gravitational field.

An assessment tool according to an embodiment of the disclosure may be a tool which makes a qualitative assessment of a sample (e.g. pass/fail), one which makes a quantitative measurement (e.g. the size of a feature) of a sample or one which generates an image of map of a sample. Examples of assessment tools are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools). The electron-optical column 40 may be a component of an assessment tool; such as an inspection tool or a metro-inspection tool, or part of an e-beam lithography tool. Any reference to a tool herein is intended to encompass a device, apparatus or system, the tool comprising various components which may or may not be collocated, and which may even be located in separate rooms, especially for example for data processing elements.

The terms "sub-beam" and "beamlet" are used interchangeably herein and are both understood to encompass any radiation beam derived from a parent radiation beam by dividing or splitting the parent radiation beam. The term "manipulator" is used to encompass any element which affects the path of a sub-beam or beamlet, such as a lens or deflector.

References to elements being aligned along a beam path or sub-beam path are understood to mean that the respective elements are positioned along the beam path or sub-beam path.

References to optics are understood to mean electron-optics.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses.

There is provided the following clauses:
Clause 1: A charged-particle apparatus comprising an optical column and configured to project a charged-particle beam towards a sample through the optical column, the charged-particle apparatus comprising: an assembly configured to operate on charged particles in the charged-particle beam or emitted from the sample in response to the charged-particle beam; an electronic device; a power source configured to output photonic radiation; and a power converter configured to receive photonic radiation from the power source, to convert the received photonic radiation into electricity and to output the electricity to the electronic device; wherein the power source is electrically isolated from the power converter.
Clause 2: A charged-particle apparatus comprising an optical column and configured to project a charged-particle beam towards a sample through the optical column, the charged-particle apparatus comprising: an electronic device comprising an integrated circuit and/or an amplifier; a power source configured to output photonic radiation; anda power converter configured to receive photonic radiation from the power source, to convert the received photonic radiation into electricity and to output the electricity to the electronic device; wherein the power source is electrically isolated from the power converter.
Clause 3: The charged-particle apparatus of claim 2, comprising: an assembly configured to operate on charged particles in the charged-particle beam or emitted from the sample in response to the charged-particle beam.
Clause 4: The charged-particle apparatus of claim 1 or 3, wherein the assembly is a detector assembly configured to detect charged particles emitted from the sample in response to the charged-particle beam.
Clause 5: The charged-particle apparatus of claim 4, wherein the detector assembly comprises the electronic device.
Clause 6: The charged-particle apparatus of claim 4 or 5, wherein the detector assembly is integrated in an objective lens assembly configured to focus the charged-particle beam on the sample.
Clause 7: The charged-particle apparatus of any preceding claim, wherein the optical column is configured to generate charged-particle beamlets from a source charged-particle beam and to project the beamlets towards the sample.
Clause 8: The charged-particle apparatus of any preceding claim, wherein at least part of the optical column is configured to operate at a potential difference of at least 50V from ground.
Clause 9: The charged-particle apparatus of any preceding claim, wherein the electronic device is provided in a location of the optical column at which the optical column is configured to operate at a potential difference of at least 50V from ground.
Clause 10: The charged-particle apparatus of any preceding claim, wherein the power source and the electronic device are provided in locations of the charged-particle apparatus at different electric potentials.
Clause 11: The charged-particle apparatus of any preceding claim, wherein the power source comprises at least one selected from the group consisting of a laser and a LED.
Clause 12: The charged-particle apparatus of any preceding claim, wherein the power converter comprises a photovoltaic cell.
Clause 13: The charged-particle apparatus of any preceding claim, comprising: a control signal emitter configured to radiate photonically a control signal; and a control signal photosensor configured to receive the control signal, to convert the control signal into an electrical control signal, and to output the electrical control signal to control the electronic device; wherein the control signal emitter is electrically isolated from the control signal photosensor.
Clause 14: The charged-particle apparatus of claim 13, wherein the control signal emitter and the control signal photosensor are comprised in an optocoupler.
Clause 15: The charged-particle apparatus of claim 13 or 14, wherein the power source is separate from the control signal emitter and the power converter is separate from the control signal photosensor.
Clause 16: The charged-particle apparatus of claim 13 or 14, wherein the power source comprises the control signal emitter and the power converter comprises the control signal photosensor.
Clause 17: The charged-particle apparatus of any preceding claim, comprising: a data signal emitter configured to radiate photonically a data signal; and a data signal photosensor configured to receive the data signal, and to convert the data signal into an electrical data signal; wherein the data signal emitter is electrically isolated from the data signal photosensor.
Clause 18: The charged-particle apparatus of claim 17, wherein the data signal emitter is at a location of elevated potential relative to a location of the data signal photosensor.
Clause 19: The charged-particle apparatus of claim 17 or 18, wherein the data signal emitter is electrically connected to the electronic device, the data signal being based on data received from the electronic device.
Clause 20: The charged-particle apparatus of any of claims 17 to 19, wherein the data signal emitter and the data signal photosensor are comprised in an optocoupler.
Clause 21: The charged-particle apparatus of any of claims 17 to 20, wherein the power source is separate from the data signal photosensor and the power converter is separate from the data signal emitter.
Clause 22: The charged-particle apparatus of any of claims 17 to 20, wherein the power source comprises the data signal photosensor and the power converter comprises the data signal emitter.
Clause 23: The charged-particle apparatus of any preceding claim, comprising a thermal conditioner configured to thermally condition the electronic device.
Clause 24: The charged-particle apparatus of any preceding claim, wherein the power source is connected to a substrate and the power converter is connected to the substrate.
Clause 25: The charged-particle apparatus of claim 24, wherein the portions of the substrate to which the power source and the power converter are located are electrically isolated from each other.
Clause 26: The charged-particle apparatus of any preceding claim, wherein the electronic device is comprised in a sensor.
Clause 27: The charged-particle apparatus of claim 26, wherein the sensor is a capacitive sensor configured to measure a position of a charged-particle-optical component of the charged-particle inspection apparatus with respect to a surface.
Clause 28: The charged-particle apparatus of claim 27, wherein the capacitive sensor is proximate a position of the sample.
Clause 29: The charged-particle apparatus of claim 28, wherein the capacitive sensor is facing the sample.
Clause 30: The charged-particle apparatus of any of claims 27 to 29, wherein the capacitive sensor is associated with a portion of the optical column proximate the sample.
Clause 31: The charged-particle apparatus of claim 30, wherein the capacitive sensor is located on the portion of the optical column proximate the sample
Clause 32: The charged-particle apparatus of any of claims 26 to 31, wherein the sensor is configured to measure a current of the charged-particle beam.
Clause 33: The charged-particle apparatus of any of claims 26 to 32, comprising: a stage for supporting the sample.
Clause 34: The charged-particle apparatus of claim 33, wherein the sensor is in the stage.
Clause 35: The charged-particle apparatus of claim 33 or 34, wherein the sensor is orientated facing in a direction towards the optical column.
Clause 36: The charged-particle apparatus of any of claims 33 to 35, wherein the sensor is in a surface of the stage.
Clause 37: The charged-particle apparatus of any of claims 33 to 36, wherein the sensor is away from the position of the sample.
Clause 38: The charged-particle apparatus of any preceding claim, wherein the charged-particle apparatus is a charged-particle inspection apparatus configured to inspect the sample with the projected charge-particle beam.
Clause 39: The charged-particle apparatus of any preceding claim, wherein the electronic device is comprised in a charged-particle-optical device configured to operate on the charged-particle beam in a path of the charged-particle beam towards the sample.
Clause 40: The charged-particle apparatus of claim 39, wherein the charged-particle beam is an array of charged-particle beams and the charged-particle-optical device comprises an array of charged-particle-optical elements corresponding to the array of charged-particle beams.
Clause 41: The charged-particle apparatus of claim 40, wherein the array of charged-particle-optical elements is an array of multipole deflectors.
Clause 42: A method of using a charged-particle apparatus, the method comprising: projecting a charged-particle beam towards a sample; operating on the charged-particle beam either in the charged-particle beam path or emitted from the sample in response to the charged-particle beam; outputting photonic radiation from a power source; receiving the photonic radiation at a power converter, the power source being electrically isolated from the power converter; converting the photonic radiation into electricity; and outputting the electricity to an electronic device of the charged-particle apparatus.
Clause 43: A method of powering a component of a charged-particle apparatus, the method comprising: emitting photonic radiation from a power source; receiving the photonic radiation at a power converter, the power source being electrically isolated from the power converter; converting the photonic radiation into electricity; and powering an integrated circuit and/or an amplifier of an electronic device with the electricity.
Clause 44: The method of claim 42 or 43, comprising: photonically radiating a control signal from a control signal emitter; receiving the control signal at a control signal photosensor, the control signal emitter being electrically isolated from the control signal photosensor; converting the control signal into an electrical control signal; and controlling the electronic device with the electrical control signal.
Clause 45: The method of any of claims 42 to 44, comprising: photonically radiating a data signal from a data signal emitter; receiving the data signal at a data signal photosensor, the data signal emitter being electrically isolated from the data signal photosensor; and converting the data signal into an electrical data signal.
Clause 46: The method of claim 45, further comprising: electrically transmitting the electrical data signal between the electronic device and the data signal emitter or the data signal photosensor.
Clause 47: The method of claim 45 or 46, further comprising: transmitting data signals to and from the electronic device, wherein the data signal comprises an inbound data signal to the electronic device and an outbound data signal from the electronic device..

The descriptions above are intended to be illustrative, not limiting. Thus, it will be apparent to one skilled in the art that modifications may be made as described without departing from the scope of the claims set out below.

## Claims

1. A charged-particle apparatus comprising an optical column and configured to project a charged-particle beam towards a sample through the optical column, the charged-particle apparatus comprising:
an electronic device comprising an integrated circuit and/or an amplifier;
a power source configured to output photonic radiation; and
a power converter configured to receive photonic radiation from the power source, to convert the received photonic radiation into electricity and to output the electricity to the electronic device;
wherein the power source is electrically isolated from the power converter.

2. The charged-particle apparatus of any preceding claim, wherein the power source and the electronic device are provided in locations of the charged-particle apparatus at different electric potentials.

3. The charged-particle apparatus of any preceding claim, wherein the power source comprises at least one selected from the group consisting of a laser and a LED.

4. The charged-particle apparatus of any preceding claim, wherein the power converter comprises a photovoltaic cell.

5. The charged-particle apparatus of any preceding claim, comprising:
a control signal emitter configured to radiate photonically a control signal; and
a control signal photosensor configured to receive the control signal, to convert the control signal into an electrical control signal, and to output the electrical control signal to control the electronic device;wherein the control signal emitter is electrically isolated from the control signal photosensor.

6. The charged-particle apparatus of claim 5, wherein the power source is separate from the control signal emitter and the power converter is separate from the control signal photosensor.

7. The charged-particle apparatus of any preceding claim, comprising:
a data signal emitter configured to radiate photonically a data signal; and
a data signal photosensor configured to receive the data signal, and to convert the data signal into an electrical data signal;
wherein the data signal emitter is electrically isolated from the data signal photosensor.

8. The charged-particle apparatus of claim 7, wherein the data signal emitter is at a location of elevated potential relative to a location of the data signal photosensor.

9. The charged-particle apparatus of claim 7 or 8, wherein the data signal emitter is electrically connected to the electronic device, the data signal being based on data received from the electronic device.

10. The charged-particle apparatus of any of claims 7 to 9, wherein the power source is separate from the data signal photosensor and the power converter is separate from the data signal emitter.

11. The charged-particle apparatus of any preceding claim, wherein the power source is connected to a substrate and the power converter is connected to the substrate.

12. The charged-particle apparatus of any preceding, comprising: an assembly configured to operate on charged particles in the charged-particle beam or emitted from the sample in response to the charged-particle beam.

13. The charged-particle apparatus of claim 12, wherein the assembly is a detector assembly configured to detect charged particles emitted from the sample in response to the charged-particle beam.

14. The charged-particle apparatus of claim 13, wherein the detector assembly comprises the electronic device, and optionally wherein the detector assembly is integrated in an objective lens assembly configured to focus the charged-particle beam on the sample.

15. The charged-particle apparatus of any preceding claim, wherein the optical column is configured to generate charged-particle beamlets from a source charged-particle beam and to project the beamlets towards the sample.
